Europäisches Patentamt

European Patent Office

Office européen des brevets

(11) Publication number: 0 378 360 A2

## EUROPEAN PATENT APPLICATION

(21) Application number: 90300231.9

(51) Int. Cl.5: G06G 7/14

(22) Date of filing: 09.01.90

(30) Priority: 09.01.89 US 295223

(43) Date of publication of application:
18.07.90 Bulletin 90/29

(84) Designated Contracting States:
DE FR GB IT

(71) Applicant: TELEDYNE INDUSTRIES, INC.
1300 Terra Bella Avenue
Mountain View California 94039(US)

(72) Inventor: Collings, Jerry M.
260 Machado Lane
San Luis Obispo California 93401(US)

(74) Representative: Tomlinson, Kerry John et al
Frank B. Dehn & Co. European Patent
Attorneys Imperial House 15-19 Kingsway
London WC2B 6UZ(GB)

(54) Analog signal conditioning without precision components.

(57) Apparatus is disclosed for performing analog computations and other analog signal conditioning with extremely high accuracy and zero DC offset. In one aspect a computational cell is described with includes first (20) and second (230) low-precision resistors each having a first and second terminal. A current is established in the first resistor through a closed-loop circuit (40,10) in which the first terminal (16) of the first resistor is connected to the second input of an error amplifier (40), and the first input of the error amplifier receives an input signal ($v_{i1}$). During a second time period, the current is maintained in the first resistor. A new current is established in the second resistor through a feedback loop (40,224) in which the first input of the same error amplifier (40) is now connected to the first terminal (228) of the second resistor, while the first terminal (16) of the first resistor (20) remains connected to the second terminal of the error amplifier (40). By holding the second terminal of the first resistor at a $V_{i2}$ voltage during the first time period and at a $V_{i3}$ voltage during the second time period, and by holding the second terminal of the second resistor at a $V_{i4}$ voltage during the second time period and at a $V_{i5}$ voltage during a third time period, the cell outputs (at the first terminal (228) of the second resistor) during the third time period a voltage $V_{02} = V_{i1} - V_{i2} + V_{i3} - V_{i4} + V_{i5}$. Extremely high accuracy analog memory apparatus is also disclosed.

FIG. IIa

## ANALOG SIGNAL CONDITIONING WITHOUT PRECISION COMPONENTS

The invention relates generally to arithmetic processing of analog signals, and more particularly to methods and apparatus for performing such operations precisely without the need for precision resistors or capacitors.

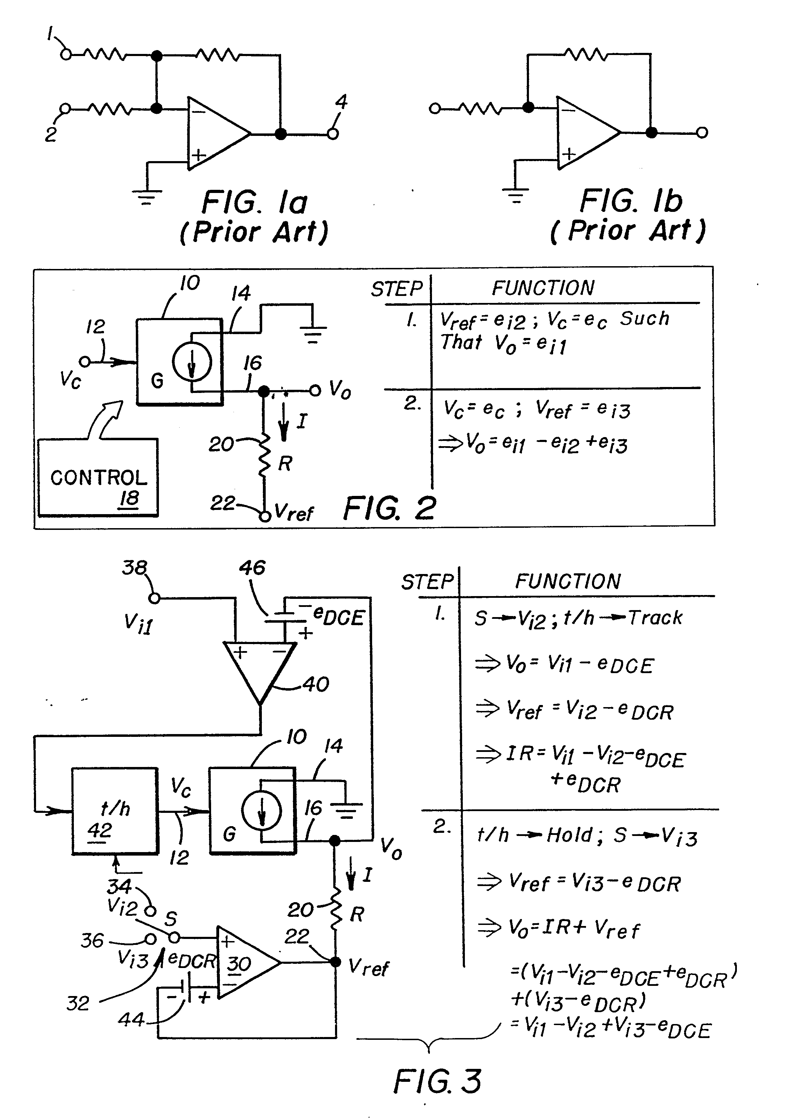

Integrated circuit manufacturers presently manufacture a large variety of analog integrated circuits. Many of these varieties include resistors or capacitors, and the precision of the output depends on how precisely the passive components are formed. For example, Fig. 1a shows a common analog circuit for summing together the voltages at two inputs 1 and 2. If all three resistors are equal, the voltage on the output 4 will be the negative of the sum of the voltages at the inputs 1 and 2. However, any inaccuracies in the resistor values will degrade the accuracy of the voltage on the output. Similarly, Fig. 1b is a signal inverter if the two resistors shown are equal, and will not be precise if the resistors are not quite equal.

The need for accurate resistors is most important in digital-to-analog converters (DACs) and analog-to-digital converters (ADCs). If resistors can be guaranteed only to ± 0.1%, then the device can have a precision of only about 10 bits before the error becomes greater than the value of the least significant bit.

Processes exist for improving the precision of resistors on an integrated circuit, but they are difficult and expensive. For example, resistors may be laser trimmed at great expense, in order to obtain precision of only about ± 0.01%. And at some point, no processes are known for further improving the precision of on-chip resistors.

It is therefore an object of the present invention to provide apparatus which can perform high-precision analog arithmetic without the need for precision resistors or capacitors.

It is another object of the present invention to provide apparatus and a method for using low-precision resistors and/or capacitors to perform high-precision analog arithmetic.

It is another object of the present invention to provide apparatus for performing high-precision digital-to-analog conversion or analog-to-digital conversion without the need for precision passive components.

It is another object of the present invention to provide apparatus for storing analog values with high precision.

It is another object of the present invention to provide apparatus to eliminate offsets and 1/f noise in linear circuits, particularly but not exclusively CMOS.

Generally, the above objects and others can be accomplished by providing a low-precision resistor having one end tied to the output of a voltage follower and the other end connected to the current output of a programmable current source The apparatus performs the function $e_{o1} = e_{i1} - e_{i2} + e_{i3}$ in a two-stage operation. In the first stage, $e_{i2}$ is applied to the input of the voltage follower and a control signal is applied to the control input of the programmable current source and adjusted until the voltage at the output of the current source equals $e_{i1}$. A current is thereby established in the resistor equal to $(e_{i1} - e_{i2})/R$, where R is the value of the resistor. In the second step, the voltage $e_{i3}$ is applied to the input of the voltage follower while the control input of the current source is held constant. Since the input of the programmable current source is held constant, the current through the resistor also remains constant as does the voltage drop across it. Thus after the input of the voltage follower is brought to $e_{i3}$, the voltage at the output of the current source is equal to $e_{i1} - e_{i2} + e_{i3}$. This voltage is highly precise, regardless of the precision of the resistor.

By substituting zero for one or more of the input voltages $e_{i1}$, $e_{i2}$ and $e_{i3}$ various degenerate cases can be obtained. For example, the difference between two voltages can be obtained by applying one of them as $e_{i1}$ and the other as $e_{i2}$ while applying 0 volts as $e_{i3}$. The sum of two voltages can be obtained by applying them as $e_{i1}$ and $e_{i3}$, while $e_{i2}$ is supplied as 0. The negative of a voltage can be obtained by applying it as $e_{i2}$ and applying 0 volts as $e_{i1}$ and $e_{i3}$. Finally, simple voltage transfer can be accomplished by providing the input voltage as either $e_{i1}$ or $e_{i3}$ and applying 0 volts for the other two inputs. Degenerate cases such as these can be obtained dynamically or, by constructing the circuit appropriately, permanently.

In one aspect of the invention, the input signal $e_{i1}$ can be connected to a first input of an error amplifier, the output of which is connected to the input of a track/hold, the output of which is connected to the input of a transconductance converter. The output of the transconductance converter is connected through the resistor to the output of the follower, and it is also connected back to the second input of the error amplifier. In this way, during the first step of the operation, the error amplifier is the device responsible for bringing the voltage of the output of the transconductance converter to the $e_{i1}$ level. The transconductance converter control voltage required to accomplish this, $e_{c1}$, is then held in the track/hold unit for the second step of the process. Any inaccuracy in the value of the resistor, the linearity or offset of the transconductance converter, and even any DC offset in the voltage follower, are all reduced by the gain of the error amplifier when the error amplifier adjusts $e_{c1}$.

In another aspect of the invention, any DC offset in the error amplifier can also be compensated in expanded apparatus which further computes a second output voltage $e_{o2} = e_{i1} - e_{i2} + e_{i3} - e_{i4} + e_{i5}$, where $e_{i4}$ and $e_{i5}$ are additional input voltages. In this expanded apparatus, a second stage is provided which includes a second track/hold unit having its input connected to the output of the error amplifier, and having its output connected to the control input of a second transconductance converter. The output of the second transconductance converter is connected through a second resistor to the output of a second voltage follower. The output of the second transconductance converter is also connected, switchably with the $e_{i1}$ voltage, to the first input of the error amplifier.

In operation, during the second step, while the first track/hold is holding $e_{c1}$ constant, the second track/hold is placed in its track mode and the first input of the error amplifier is set to receive the voltage of the output of the second transconductance converter. Since the voltage $e_{o1}$, as affected by the DC offset in the error amplifier, is still connected to the second input of the error amplifier, the error amplifier will now during this second step adjust its output voltage until it finds voltage $e_{c2}$ at which the voltage at the output of the second transconductance converter equals $e_{o1}$. However, since the functions of the two inputs of the error amplifier are now reversed, any offset which the error amplifier introduced into $e_{o1}$ is now cancelled out. This effect is explained in more detail below.

Additionally during this second step, $e_{i4}$ is applied to the input of the second voltage follower so that the voltage across the second resistor becomes $e_{o1} - e_{i4}$. In a third step in the operation of the apparatus, the second track/hold unit is set to hold its value $e_{c2}$ while the input of the second voltage follower is changed to $e_{i5}$. Thus, in the same manner as the first stage of the apparatus, the output of the second transconductance converter will during the third time period reach a voltage equal to $e_{o2} = e_{o1} - e_{i4} + e_{i5} = e_{i1} - e_{i2} + e_{i3} - e_{i4} + e_{i5}$.

As with the output of the first stage, the output of the second stage of the apparatus is highly precise regardless of any inaccuracies in the second resistor value, linearity and/or offset in the second transconductance converter, or DC offset in the second voltage follower. Moreover, the computation is now also independent of any DC offset in the error amplifier due to the cancelling effect described above. As an additional benefit, the $1/f$ noise is also eliminated at D.C. and reduced at 6 db per octave going down from half the sampling frequency.

It is to be noted further that during the third time period, none of the inputs to the first stage are being used, including the first input to the error amplifier. Thus, the third time period can double as the first time period of the next operation for the cell to perform. Moreover, the two-stage cell described above may be cascaded with other cells or otherwise connected as desired to build larger and/or more specialized systems. For example, the cell may be used in systems which generate the absolute value of a voltage, perform step-wise integration, multiply or divide input voltages by integers, or perform digital-to-analog or analog-to-digital conversion, among other things. The cell may also be modified to act as a high-precision analog comparator without DC offset. All these functions are accomplished with extremely high precision and without the need for any precision passive components.

In still a further aspect of the invention, an approximation circuit may be used to approximate the control voltage which would otherwise be held in either of the track/hold units, which approximation voltage is added to the voltage output of the track/hold for application to the transconductance converter. This minimizes the voltage swing which the track/hold must handle, thereby permitting that voltage to be amplified prior to the track/hold and correspondingly attenuated after the track/hold. This may be accomplished simply by placing an attenuator between the track/hold output and the transconductance converter, since the error amplifier will automatically provide the necessary amplification. This construction beneficially attenuates the effect of the hold step which degrades the accuracy of most track/hold outputs. The principle of the approximation circuit can also be used in a stand alone track/hold circuit to create an enhanced analog memory cell.

The approximation circuit can comprise a high-speed ADC, the digital output of which is connected to the input of a digital latch, the output of which is connected to the input of a DAC. The ADC and DAC can both be low precision devices. The latch is placed in a flow-through mode when the track/hold is in its track mode, and in a holding mode when the track/hold is in its hold mode.

The invention will be described with respect to particular exemplary embodiments thereof, and reference will be made to the drawings in which:

Figs. 1a and 1b are schematic diagrams of prior art analog arithmetic circuits;

Figs. 2, 3, 8, 10, 11a, 21 and 22 are schematic diagrams of analog computational apparatus according to the invention;

Fig. 4 is a schematic diagram of an analog switch for use with the invention;

Fig. 5 is a schematic diagram of a prior art track/hold circuit;

Figs. 6 and 7 are schematic diagrams of stand-alone analog memory cells according to the invention;

Fig. 9 is a schematic diagram of the transconductance converter shown in Fig. 8;

Fig. 11b is a table describing the operation of the circuit of Fig. 11a;

Figs 12-18 are schematic diagrams of various analog functional blocks which incorporate a cell or cells according to the invention; and

Fig. 19 is a schematic diagram of a zero offset analog comparator according to the invention.

Fig. 20 is a schematic diagram of an approximation circuit usable with the invention.

Fig. 2 shows core features of apparatus which may be used to implement the present invention. It consists of a transconductance converter 10, having a control input 12 and two current path terminals 14 and 16. Control means 18 is also shown for controlling the sequential operation of the circuit. The transconductance converter 10 causes a current I to flow from the first current path terminal 14 to the second current path terminal 16 according to a transfer function G of the input voltage $V_c$ at the control input 12. The first current path terminal 14 is connected to ground or to some other source of current, and the second current path terminal is connected through a resistor 20, having resistance R, to a reference node 22. The voltage output $V_o$ is the voltage of the second current path terminal 16 of the transconductance converter 10.

The apparatus of Fig. 2 is operated by control means 18 to calculate an output voltage $e_o = e_{i1} - e_{i2} + e_{i3}$, where $e_{i1}$, $e_{i2}$ and $e_{i3}$ are analog input voltages, by following the two step operation set out in the table of Fig. 2. In the first step, which takes place during a first time period, the node 22 is set to the $e_{i2}$ input voltage and the control input 12 to the transconductance converter 10 is adjusted to whatever voltage $e_c$ causes the voltage at current path terminal 16 to equal the input voltage $e_{i1}$. Thus, during this first time period, a current I is established through the resistor 20 such that the voltage drop across the resistor 20 equals $e_{i1} - e_{i2}$. The voltage of the $V_o$ node, however, is still equal to $e_{i1}$.

In a second step, which occurs during a second time period subsequent to the first time period, the voltage $e_c$ is maintained at the control input of the transconductance converter 10 while the voltage of the reference node 22 is changed to $e_{i3}$. The voltage at the output node $V_o$ according to

standard circuit analysis techniques is now equal to $IR + e_{i3}$. But as long as R has not changed since step 1, the voltage drop across the resistor 20 during the second step is still equal to $IR = e_{i1} - e_{i2}$. The voltage at the $V_o$ node during the second step, therefore, is equal to $V_o = e_o = e_{i1} - e_{i2} + e_{i3}$.

The accuracy of the resulting voltage $e_o$ is independent of the accuracy of resistor 20. It is also independent of the gain accuracy, linearity and offset of transconductance converter 10. Indeed, for the present embodiment it is important only that the transfer function G be such: (1) that an input voltage $e_c$ exist which will generate the desired output current I for any desired values of input voltages $e_{i1}$ and $e_{i2}$; and (2) that once the proper $e_c$ is found, maintenance of $e_c$ on the control input of the transconductance converter will result in maintenance of the same current output I. Moreover, the current source 10 in Fig. 2 need not even be a transconductance converter if it has a current output and satisfies the above two conditions. For example, it may be a current controlled current source.

Fig. 3 is a schematic diagram including the core apparatus shown in Fig. 2, and further including additional apparatus for operating the core apparatus. In particular, in addition to the transconductance converter 10 and resistor 20, the apparatus of Fig. 3 further includes a reference voltage follower 30 having its output node connected to the $V_{ref}$ node 22 and also fed back to its inverting input. The non-inverting input of reference voltage follower 30 is connected to the common of a switch 32 capable of connecting the non-inverting input of reference voltage follower 30 to either of two input nodes $V_{i2}$ and $V_{i3}$, also designated 34 and 36, respectively. A $V_{i1}$ input node 38 is connected to the non-inverting input of an error amplifier 40, the output of which is connected to the input of a track/hold unit 42. Track/hold unit 42 also has a control input, for selecting between track and hold modes. In the track mode, the output of track/hold unit 42 follows its input, whereas in the hold mode, the output is held at whatever voltage was present when the track/hold unit 42 was placed in the hold mode. The output of track/hold unit 42 is connected to the control input 12 of the transconductance converter 10. Additionally, the $V_o$ output node, which is the second current path terminal 16 of the transconductance converter 10, is connected to the inverting input of the error amplifier 40.

It will be seen that the reference voltage follower 30 and the error amplifier 40 should both have very high gain, but high enough gain is available with conventional op amps available commercially today. These amplifiers are therefore assumed to have infinite gain. The DC offset of modern op amps is still significant, however, especially MOS op amps, so the DC offset of reference voltage follower 30 and error amplifier 40 will be taken into account in the present discussion. The DC offset of reference voltage follower 30 is designated $e_{DCR}$, and is represented as a battery 44 in series with the inverting input of the reference voltage follower 30. Similarly, the DC offset of the error amplifier 40 is designated $e_{DCE}$, and is represented as a battery 46 in series with the inverting input of error amplifier 40.

In order to perform the analog calculation $e_o = e_{i1} - e_{i2} + e_{i3}$, the various components of the circuit of Fig. 3 are operated so as to supply to the various circuit nodes the same voltages as are applied to the circuit of Fig. 2. Initially, $e_{i1}$ is applied to the input node $V_{i1}$; $e_{i2}$ is applied to the input node $V_{i2}$ and $e_{i3}$ is applied to the input node $V_{i3}$. In the first time period, as shown in the table of Fig. 3, the switch 32 is switched to connect the $V_{i2}$ node 34 to the non-inverting input of reference voltage follower 30 and the control input to the track/hold unit 42 is set appropriately such that the track/hold unit 42 is in its track mode. In this situation, the error amplifier 40 will adjust its output until the voltage at its inverting input equals the voltage at its non-inverting input.

Since the non-inverting input is at $e_{i1}$, and taking the DC offset of the error amplifier 40 into account, the voltage at the $V_o$ node during this first time period will therefore equal $e_{i1} - e_{DCE}$. Additionally, since the non-inverting input of reference voltage follower 30 is at voltage $e_{i2}$, the reference voltage node 22 is at $V_{ref} = e_{i2} - e_{DCR}$ during this first time period. Thus, during this first time period, the error amplifier 40 adjusts the control voltage $V_c$ of the transconductance converter 10 to a voltage $e_c$ such that the transconductance converter 10 generates a current I, where $IR = (e_{i1} - e_{DCE}) - (e_{i2} - e_{DCR})$.

In the second time period, subsequent to the first time period, the control input of the track/hold unit 42 is set to the value appropriate to place the track/hold unit 42 in its hold mode, thereby maintaining $e_c$ as the voltage on the control input 12 to the transconductance converter 10. The current output I through the resistor 20 therefore also remains constant. Also during this second time period the switch 32 is switched to the $V_{i3}$ input node 36, thereby applying at the $V_{ref}$ node 22 a voltage $V_{ref} = e_{i3} - e_{DCR}$. According to Ohm's Law, therefore, the voltage at the output node $V_o$ will be, during this second time period, equal to $V_o = IR + V_{ref}$. Substituting, it can be seen that the offset voltage $e_{DCR}$ of the reference voltage follower 30 cancels and the output voltage becomes $V_o = e_o = e_{i1} - e_{i2} + e_{i3} - e_{DCE}$.

Additional apparatus is described below which cancels the offset $e_{DCE}$, but it can be seen that as long as an error amplifier 40 is used which has a small offset $e_{DCE}$, the apparatus of Fig. 3, as operated using the steps set forth in Fig. 3, will generate at the output node $V_o$ an output voltage $e_o$ substantially equal to $e_{i1} - e_{i2} + e_{i3}$. Moreover, as desired, the value of the resistor 20 does not affect the accuracy of the result. Nor does any non-linearity or offset in the transfer function G of the transconductance converter 10, the offset in the reference voltage follower 30, or any insertion loss caused by the use of track/hold unit 42.

In terms of the practical implementation of the circuit of Fig. 3, certain considerations should be noted. First, as already mentioned, the error amplifier 40 should have very high gain. For example, if the apparatus is used in a 12-bit DAC or ADC, the open loop gain of the error amplifier 40 should be at least 10,000. This is easily achieved in modern commercially available op amps.

Another consideration is that all the current output from the transconductance converter 10 should flow through the resistor 20. This is achieved by ensuring that the inverting input of error amplifier 40, as well as the input to any subsequent stages connected to the $V_o$ node, all have high impedance. This, too, is easily accomplished with modern circuits, especially in MOS devices.

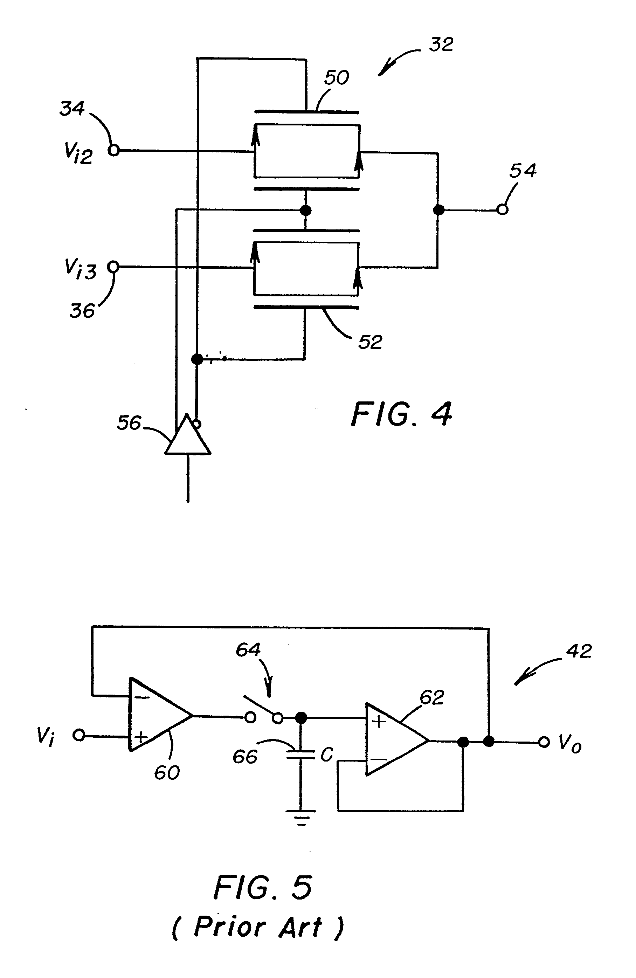

Still another consideration is that the current path terminal 16 of the transconductance converter 10 should have a very high output impedance so that the current I does not change when the $V_{ref}$ node 22 changes from $e_{i2} - e_{DCR}$ to $e_{i3} - e_{DCR}$. This, too, is easily accomplished using modern circuits. For example, a usable transconductance converter is shown in Fig 4.124 at page 253 of Gregorian, "Analog MOS Integrated Circuits For Signal Processing" (New York: Wiley, 1986) The output impedance of the transconductance amplifier may be further enhanced using well-known techniques.

In another consideration, since the apparatus now includes a feedback loop for establishing $e_c$, G must be such that the voltage on the $V_c$ node will converge on the proper value. This consideration is easy to meet since, typically, $I = G(V_c)$ is a monotonically increasing function. The requirement may also be met by reversing the inputs to error amplifier 40 and making $G(V_c)$ a monotonically decreasing function.

Yet another consideration concerns the switch 32. In order to accommodate the full range of input voltages, the switch 32 can be constructed in MOS technology using well-known transmission gates as shown in Fig. 4. Two transmission gates are used, designated 50 and 52. Transmission gate 50 has its signal input connected to the $V_{i2}$ node 34 and its signal output connected to the common 54 of the switch 32. Transmission gate 52 has its signal input connected to $V_{i3}$ node 36 and also has its signal output connected to the common 54. The switch 32 switches between the $V_{i2}$ and $V_{i3}$ inputs according to a signal provided at the input of a buffer 56, which has both an inverting and a non-inverting output. These outputs of buffer 56 are connected to the gates of the transmission gate 50 and 52 transistors such that when the input of buffer 56 is high, transmission gate 50 conducts and transmission gate 52 turns off, and when the input to buffer 56 is low, transmission gate 52 conducts and transmission gate 50 turns off.

Transmission gates such as 50 and 52 are well known in the art, and may well include a series resistance. The series resistance is not detrimental, however, since it is still much less than the input impedance of the non-inverting input of reference voltage follower 30 Track/hold unit 42 may also include a transmission gate, but any series resistance inserted by the transmission gate here is unimportant for the same reason. Moreover, any error introduced by reason of a series resistance in the track/hold 42 will be compensated since the track/hold 42 is inside the feedback loop including error amplifier 40.

Yet another consideration concerns the track/hold unit 42. A typical track/hold unit is shown in Fig. 5, and it consists of operational amplifiers 60 and 62, single-pole single-throw switch 64 and capacitor 66. The input signal is connected to the non-inverting input of amplifier 60, the output of which is connected through the switch 64 to the non-inverting input of the amplifier 62. The inverting input of amplifier 62 is connected to the output of amplifier 62, which also forms the output of the track/hold unit 42. It is also fed back to the inverting input of both amplifiers 60 and 62. The capacitor 66 is coupled between the non-inverting input of amplifier 62 and ground.

In operation, the track/hold unit shown in Fig. 5 is in the track mode when the switch 64 is closed. In this situation, amplifier 60 adjusts its output (and hence the non-inverting input of amplifier 62) to whatever voltage is necessary to bring the inverting input of amplifier 60 to a voltage equal to that of the input of the track/hold unit 42. Since the inverting input of the amplifier 60 is connected to the output of the track/hold, the output of the track/hold effectively follows the input during the track mode. In the meantime, the voltage on capacitor 66 is forced to change accordingly. Then, the switch 64 is opened in order to put the track/hold into its hold mode. In this situation the capacitor 66 continues to maintain the voltage across it which is had just before switch 64 was opened. It therefore applies to the non-inverting input of amplifier 62 whatever voltage is necessary to maintain the output voltage of the track/hold at the same voltage which was present just before the switch 64 was opened.

The conventional track/hold circuit of Fig. 5 is satisfactory in many applications of the present invention. However, that circuit as well as many other conventional track/hold circuits suffers from two well-known problems which could limit the accuracy of the analog computations achievable with the invention. The first problem is that though not shown in Fig. 5, switch 64 includes a control line which changes from one logic level to another in order to open the switch. In real-world switches, a parasitic capacitance exists between this control line and each of the signal terminals of the switch. Thus, when the switch is opened, a step (either positive or negative) will appear on the capacitor voltage. This step, called a hold step, is an inaccuracy which could degrade the results.

The second problem is that capacitors lose charge over time. Thus the voltage on the output of the track/hold will have a tendency to droop.

Either of these problems could degrade the results of an analog computation performed by the circuit of Fig. 3, since, as previously mentioned, the accuracy of the result depends in part on the maintenance of the same current I through the resistor 20 during the second time period as was present during the first time period.

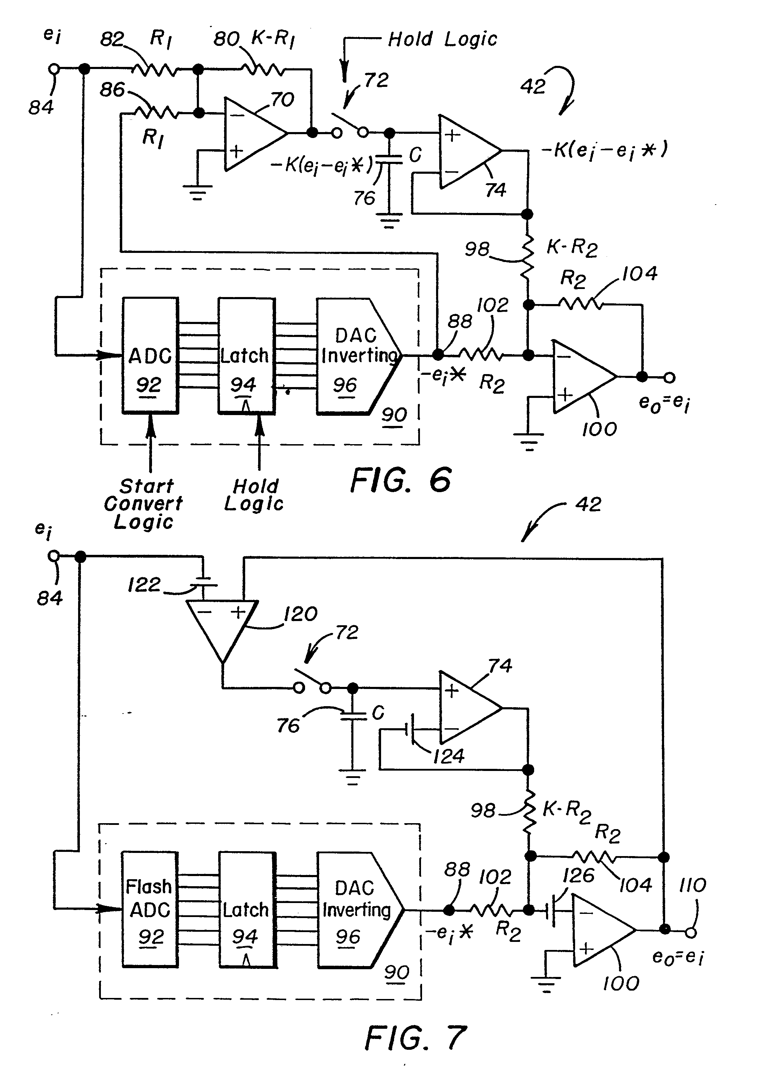

In one aspect of the invention, these problems are minimized through the use of an approximation mechanism. Fig. 6 shows an enhanced track/hold circuit which incorporates this aspect of the invention. At the core of the circuit is the conventional operational amplifier 70, switch 72 and operational amplifier 74. The output of the operational amplifier 70 is connected through the switch 72 to the non-inverting input of amplifier 74. A capacitor 76 is connected between the non-inverting input of amplifier 74 and ground. The amplifier 70 is connected as a summer; the output is connected through a resistor 80 to the inverting input of the amplifier 70, which is also connected through a resistor 82 to the track/hold input node 84 and through a resistor 86 to a node 88 described below. The resistors 82 and 86 each have a value $R_1$, whereas the feedback resistor 80 has a value of $KR_1$, where K is a constant. The amplifier 74 is connected as a voltage follower, with its output connected directly back to its inverting input.

The track/hold input node 84 is further connected to the input of an approximation circuit 90, which generates at its output node 88 an inverted approximation of the voltage at the input node 84. As previously mentioned, this approximation is coupled through the resistor 86 to the inverting input of amplifier 70. Advantageously, the approximation circuit 90 comprises an ADC 92, which quickly generates a low-precision digital representation of the input voltage; a digital latch 94 having its input port connected to the digital output of the ADC 92; and a high-speed, low-precision inverting DAC 96 having its digital input port connected to the output of the latch 94.

The output of voltage follower 74 is connected through a resistor 98 to the inverting input of an inverting summing amplifier 100, the output of which forms the output of the track/hold circuit 42. The output node 88 of the approximation circuit 90 is also connected through a resistor 102 to the inverting input of amplifier 100, and the output of the amplifier 100 is also fed back to the inverting input of the amplifier 100 through a resistor 104. Resistors 102 and 104 each have a value of $R_2$, and resistor 98 has a value of $KR_2$.

In operation, an input signal $e_i$ is applied to the input 84 of the track/hold circuit 42. The track/hold circuit 42 of Fig. 6 is placed into its track mode by closing switch 72 and placing latch 94 in a flow-through mode. In this situation, after being given a start convert signal, the flash ADC 92 quickly generates a digital approximation of the input voltage $e_i$. The digital approximation passes through latch 94 and is converted back to an analog signal $-e_i^*$ at the output node 88 of the approximation circuit 90. The elements in the approximation circuit 90 are chosen to trade off precision in favor of speed. Thus, if the ADC 92 has a 6-bit digital output, the negative of the output signal, $e_i^*$, will approximate the input signal $e_i$ with a precision of approximately ±1.6%.

Amplifier 70 is an inverting summing amplifier, which generates an output voltage equal to $-K(e_i - e_i^*)$. Since the approximation $e_i^*$ is within 1.6% of the input voltage $e_i$, if K were equal to 1, the output of amplifier 70 would have a swing of only ±1.6% of the swing of the input voltage. K may be a large number, 50 for example, so as to bring the swing back up to approximately the swing of the input voltage $e_i$. The reasons for this are explained below.

Since switch 72 is closed in the track mode, the voltage on capacitor 76 will also be at $-K(e_i - e_i^*)$, as will the voltage at the output of follower 74. Inverting summing amplifier 100 then subtracts $-e_i^*$ from 1/K times the voltage at the output of follower 74 and inverts the result to regenerate $e_o = e_i$.

When the circuit of Fig. 6 is placed into the hold mode, the output of latch 94 is latched and the switch 72 is opened. This fixes the voltages at the output of the approximation circuit 90 and at the output of amplifier 74 at their most-recent values. The output voltage $e_o$ is therefore also held at its most-recent value. Since the value of resistor 98 is K times the value of resistor 102, however, the effect on $e_o$ of the hold step is attenuated by a factor of K. This is made possible by the fact that a voltage equal to K times only a small fraction of the input voltage is stored on the capacitor 76. When this voltage is divided by K as it passes through output amplifier 100, the voltage of the hold step introduced by switch 72 is also divided by K. Thus, if for example K = 50, the effect of the hold step on the accuracy of track/hold 42 is reduced by a factor of 50 through the use of approximation circuit 90.

It can be seen that the use of approximation circuit 90 permits various trade offs in the design of a track/hold such as 42. For example, instead of using a large K, K may be made small, for example K = 1, and a much larger capacitor substituted for capacitor 76. This, too, would substantially reduce the effect of the hold step. It would also reduce voltage droop on the capacitor 76, since the voltage on the capacitor would never exceed ±1.6% of the supply voltage. As another alternative, K may be made small and the capacitor 76 may be made small, so as to increase the speed of the circuit. Other variations and trade-offs will be apparent.

Though the circuit of Fig. 6 provides significant advantages over prior art track/hold circuits, its accuracy does depend on the accuracy of the resistors. This is not a problem if the circuit of Fig. 6 is used as the track/hold circuit 42 in Fig. 3, since, once again, any errors introduced by the inaccuracies are compensated by the error amplifier 40. However, the effect of resistor inaccuracies may be minimized in a stand-alone analog memory circuit using the principles of the invention using the circuit design shown in Fig. 7. The main difference between Fig. 7 and Fig. 6 is that Fig. 7 is a closed-loop circuit whereas Fig. 6 is an open-loop circuit. Since Fig. 7 is a closed-loop circuit, errors introduced by inaccuracies in low-precision components are automatically reduced.

Referring to Fig. 7, the track/hold circuit 42 includes an approximation circuit 90 as in the circuit of Fig. 6, which is made up of an ADC 92, the output of which is connected to the input of a latch 94, the output of which is connected to an inverting DAC, the output of which is connected to an approximation node 88. The input of the ADC 92 is connected to the input node 84 of the track/hold 42. Also like the circuit of Fig. 6, the approximation node 88 is coupled through a resistor 102 to the inverting input of an output amplifier 100, the non-inverting input of which is connected to ground and the output of which forms the output 110 of the track/hold circuit 42. The output of amplifier 100 is also fed back to the inverting input via a resistor 104, and the inverting input of the amplifier 100 is also connected through a resistor 98 to the output of a voltage follower 74. The inverting input of the voltage follower 74 is connected directly to the output of the voltage follower 74, and the non-inverting input is connected to one terminal of a switch 72 and also through capacitor 76 to ground. Once again, as in Fig. 6, resistors 102 and 104 each have a value $R_2$, and resistor 98 has a value $KR_2$.

Unlike the circuit of Fig. 6, the other signal terminal for the switch 72 is not connected to the output of a summing inverting amplifier such as 70. Instead, it is connected to the output of an error amplifier 120. The inverting input of the error amplifier 120 is connected to the track/hold input node 84, and the non-inverting input is connected to the track/hold output node 110.

Also shown in Fig. 7 are batteries 122, 124 and 126 representing the DC offsets of, respectively, operational amplifiers 120, 74 and 100. Each is shown connected serially with the inverting input of the respective amplifier.

In operation, when the track/hold of Fig. 7 is in the track mode, switch 72 is closed and latch 94 is in its flow-through mode. Thus, as previously explained with respect to Fig. 6, the approximation node 88 has a voltage on it equal to the inverse of an approximation $e_i^*$ of the input voltage $e_i$. The voltage $e_i^*$ approximates the input voltage $e_i$ to within ±1.6% (for a 6-bit ADC). The approximation voltage $e_i^*$ is added by inverting summing amplifier 100 to 1/K times the voltage at the output of voltage follower 74, and the result is fed back to the error amplifier 120.

Error amplifier 120 adjusts its output voltage to whatever voltage is required to bring its two inputs to the same voltage. Thus, by adjusting its output voltage, error amplifier 120 ensures that the output voltage $e_o$ equals the input voltage $e_i$ (plus the offset of error amplifier 120) while switch 72 is closed. It can be seen, therefore, that any inaccuracies in the resistors 98, 102 and 104 will not affect the accuracy of the output $e_o$. Nor will the DC offset voltages of operational amplifiers 74 and 100, since any error they introduce is automatically compensated by the error amplifier 120. Nor will any errors in the approximation circuit 90 affect the accuracy of the output voltage $e_o$. In fact, a circuit 90 can be used which provides even a very poor approximation of the input voltage $e_i$, or even an approximation of some other voltage. The error introduced by the DC offset of error amplifier 120, however, remains

It should be noted that though the latch 94 in both Figs. 6 and 7 are referred to as having a flow-through mode and a latching mode, it can be seen that the flow-through mode is not absolutely necessary. For example, the latch 94 may be constructed from master/slave D flip-flops, in which the input signal is latched on one edge of a clock pulse and transferred to the output on the other edge. Assuming the input signal does not vary too quickly relative to the time period between the two edges of the clock pulse, the voltage output of the DAC 96 will still be a good approximation of the input voltage and will still permit the use of a large value of K.

Nor must the approximation circuit 90 be a DAC/latch/ADC combination as shown in Fig. 7. Another possible circuit for approximation circuit 90 could be ordinary analog storage of the input signal $e_i$ as it existed in the previous cycle, that is, prior to the most recent placement of the circuit into the track mode. Since analog signals usually do not change very quickly, the previous level of $e_i$ will usually be a good approximation of the next level. Such an approximation circuit would probably occupy less chip space than the ADC/latch/DAC circuit shown in Figs. 6 and 7, but unless a limit is specified on the rate of change of the input voltage $e_i$, the voltage swing on capacitor 76 will not be predictable. The value of K will then probably have to be much lower, thereby degrading the advantages of the circuit.

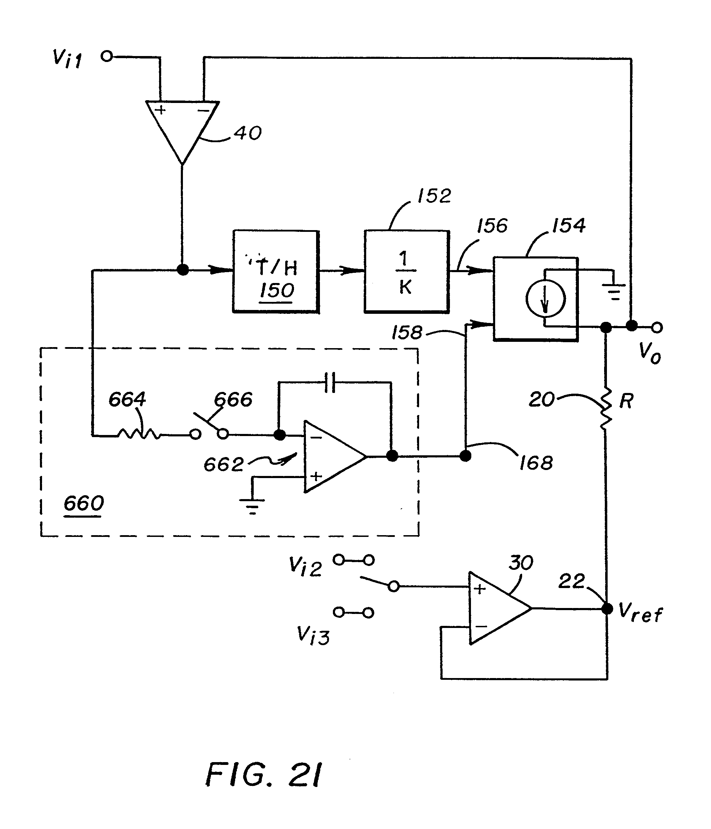

A preferred choice for approximation circuit 90 is shown in Fig. 20. It is a standard, completely analog, track/hold employing two op amps coupled in series. The first op amp is connected as a voltage follower, and the second is connected as an amplifier. The track/hold switch and storage capacitor precede the first op amp, which has an MOS input in order to minimize droop. Otherwise, neither the size of the hold step nor the accuracy of the resistors, capacitor or op amps in the approximation circuit 90 are important since any inaccuracies introduced are automatically compensated by the feedback loop (Fig. 7).

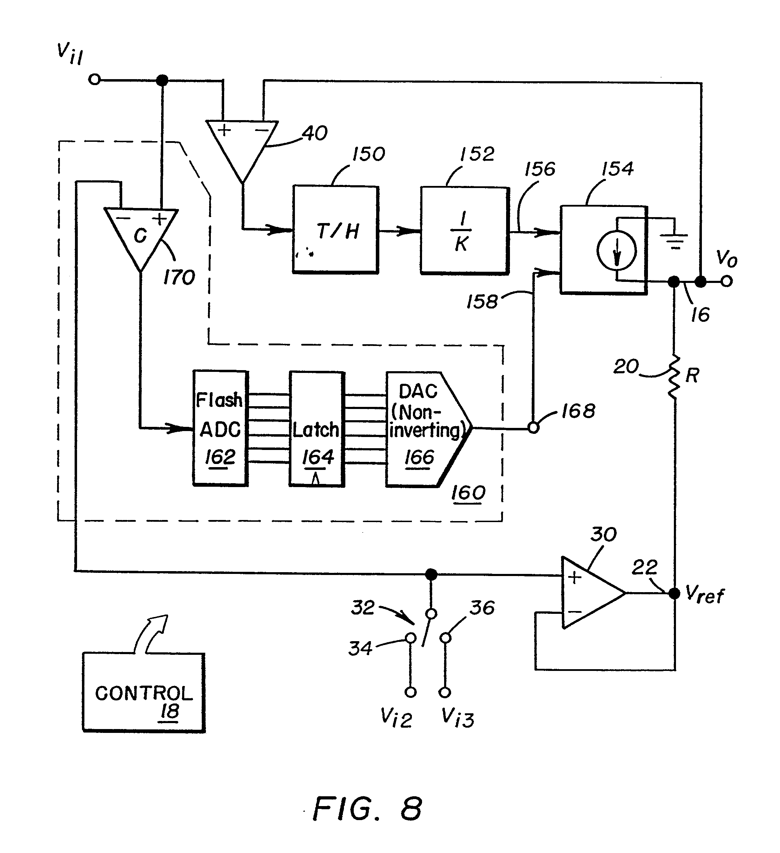

Another preferred choice for an approximation circuit is shown as 660 in Fig. 21. Approximation circuit 660 comprises a standard integrator preceded in series by a resistor 664 and switch 666. Unlike the approximation circuit 160 in Fig. 8, for example, the approximation voltage is here derived from the output of the error amplifier. In operation, the error at the output of the error amplifier drives the integrator 662 until the output voltage at node 168 is approximately the correct voltage. Switch 666 is then opened, though the track/hold unit 150 is maintained in its track mode. Then, since the integrator 662 is of low quality and high speed, the output jumps pursuant to its hold step and the voltage at 168 is no longer correct. Since the track/hold unit 150 is still in its track mode, however, a feedback loop still exists (through the track/hold unit 150, the attenuator 152, the converter 154 and the error amplifier 40). Thus the output at the $V_o$ node will be brought back to the correct voltage. Finally, the track/hold unit 150 is placed in its hold mode, but the hold step thereby generated is attenuated as previously explained.

The approximation circuit 660 in Fig. 21 is smaller than the approximation circuit 160 in Fig. 8, but requires more time to settle.

Returning to the implementation of Fig. 7, as explained previously, K may be equal to 1 in which case the voltage swing on the capacitor 76 will not exceed 1.6% of the voltage swing of the input voltage $e_i$. Alternatively, K may be made equal to 50, for example, in which case the voltage swing on the capacitor 76 will be much closer to the voltage swing of the input $e_i$. As previously explained, both alternatives, as well as various intermediate alternatives, provide advantages related to the hold step, speed, or charge retention, and the designer may chose between them. Prior memories had no provision for such a choice. It will also be seen below that even an error such as that introduced by the DC offset of the error amplifier 120 can be compensated through the use of a second stage.

The enhanced memory of Fig. 6 or 7 may be used directly in place of the track/hold circuit 42 in Fig. 3. Advantageously, however, the function of error amplifier 120 (Fig. 7) is accomplished by error amplifier 40 (Fig. 3). In Fig. 8 there is shown a circuit for, as in Figs. 2 and 3, performing the analog calculation $e_o = e_{i1} - e_{i2} + e_{i3}$. The analog computational circuit of Fig. 8 includes the error amplifier 40 as in Fig. 3, a track/hold 150 connected to the output of the error amplifier 40, a 1/K attenuator 152 connected to the output of track/hold 150, and a transconductance amplifier 154. The transconductance amplifier 154 has two inputs 156 and 158, the first of which is connected to the output of attenuator 152. Like the circuit of Fig. 3, the output of the transconductance converter 154 is coupled through a resistor 20 to the output node 22 of a voltage reference amplifier 30, the inverting input of which is connected to the node 22 and the non-inverting input of which is connected to the common of switch 32. The two poles 34 and 36 of switch 32 are connected, respectively, to $V_{i2}$ and $V_{i3}$ input nodes as in the circuit of Fig. 3. Additionally as in the circuit of Fig. 3, the output node 16 of the transconductance converter 154 is fed back to the inverting input of error amplifier 40, and also forms the $V_o$ output node of the analog arithmetic unit. The non-inverting input of error amplifier 40 is connected to the computational unit input node $V_{i1}$.

In addition to these elements, there is also provided an approximation circuit 160, consisting of, as in Figs. 6 and 7, an ADC 162, the digital output of which is connected to the input of a latch 164, the output of which is connected to the digital input of a non-inverting DAC 166. The output node 168 of the DAC 166 is also the output node of the approximation circuit 160, and connects to the second input 158 of the transconductance converter 154. Also inside the approximation circuit 160, the analog input of the ADC 162 is connected to the output of an operational amplifier 170 connected to produce the difference between the voltage at the $V_{i1}$ input node and the voltage at the common of switch 32, multiplied by some constant which is set internally to the op amp. Thus, the common of switch 32 is connected to the inverting input of amplifier 170, and the computational unit input node $V_{i1}$ is connected to the non-inverting input of amplifier 170. This particular configuration for op amp 170 is chosen so as to minimize the load on the input voltage at node $V_{i1}$.

The individual elements of Fig. 8 are all conventional, and the considerations described above with respect to the elements of Fig. 3 apply. Additionally, it will be seen that track/hold circuit 150 may be very basic, since its accuracy is enhanced by the approximation circuit 160. Similarly, the attenuator 152 may be as simple as a low-precision resistor divider.

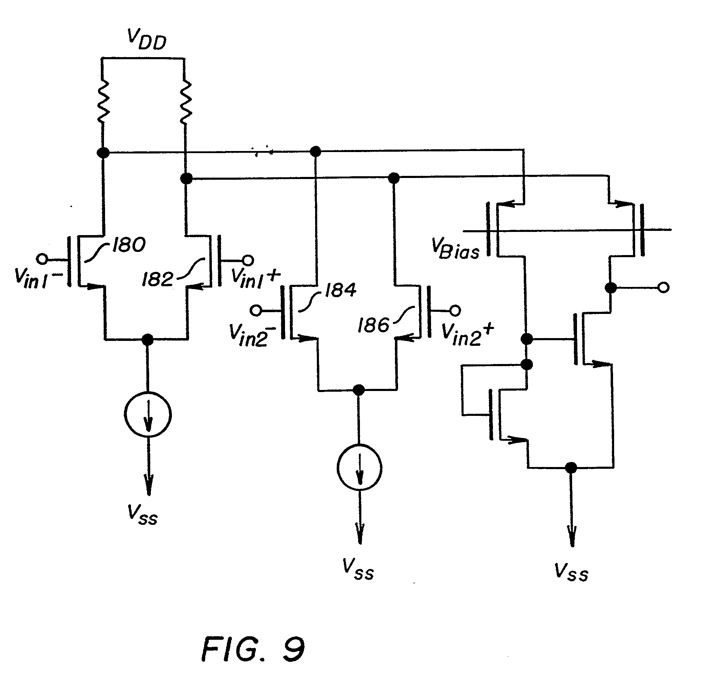

Transconductance amplifier 154 is different from transconductance amplifier 10 in Fig. 3, since it has two voltage control inputs 156 and 158. The purpose of transconductance amplifier 154 is to output a current having a level approximately equal to the sum of the current level due to control input 156 and the current level due to the control input 158. Such a circuit is conventional, and a typical example is shown in Fig. 9. The circuit of Fig. 9 will not be desoribed in detail, except to note that it includes two differential pairs of input nodes, the first pair being the gates of transistors 180 and 182 and the second pair being the gates of transistors 184 and 186. The gates of transistors 180 and 184 are inverting inputs, and the gates of transistors 182 and 186 are non-inverting inputs. Thus, in order to generate a current approximately equal to the sum of the currents due to two non-inverting voltage control inputs, these controls inputs are connected to the gates of transistors 182 and 186 and the gates of transistors 180 and 184 are tied to ground.

Other variations will be apparent. For example, if DAC 166 (Fig. 8) has an inverting output rather than a non-inverting output, then the two voltage control inputs 156 and 158 may be connected to the two inputs of a single differential pair in a conventional subtracting manner. In this case the second differential pair 184 and 186 (Fig. 9) may be omitted.

Referring to Figs. 6, 7 and 8, the purpose of the approximation circuitry 90 (Figs. 6 and 7) and 160 (Fig. 8) is to generate a voltage which approximates the voltage which the remainder of the circuit would have to supply to the transconductance converter if the approximation circuit was omitted.

For K = 1, this minimizes the voltage swing on the capacitor 76 (Figs. 6 and 7) or the capacitor in track/hold 150 (Fig. 8); alternatively, it permits the largest value of K. Thus, for a stand alone analog memory such as that shown in Figs. 6 or 7, the approximation circuitry approximates the input voltage $e_i$. This minimizes the K = 1 voltage swing on the capacitor 76 since the voltage on capacitor 76 is essentially the difference between $e_i$ and its approximation.

In the analog computational circuit of Fig. 3, the voltage stored on the capacitor in the track/hold unit 42 is essentially $V_c = G^{-1}[(V_{i1} - V_{i2})/R)]$. Assuming $G \cdot R$ is approximately equal to unity, then the voltage which will be placed on the capacitor in the track/hold unit 42 in Fig. 3 during the first time period of the two-step operation will be approximately equal to $V_{i1} - V_{i2}$.

Referring to Fig. 8, it can be seen that this is the voltage which is approximated at the output 168 of the approximation circuit 160. Operational amplifier 170 is connected to calculate the difference between two analog signals, the two signals being $V_{i1}$ and $V_{i2}$ ($V_{i2}$ being supplied through switch 32). Additionally, if G is not equal to 1/R, the approximation generated at node 168 may be scaled by changing the value of C appropriately. It is noteworthy that the analog subtraction performed by the operational amplifier 170 need not be exact.

The operation of the computational circuit of Fig. 8 is similar to that previously described with respect to Fig. 3. Basically, it forms an output voltage $e_o = e_{i1} - e_{i2} + e_{i3}$ in a two-step operation. In the first step the track/hold circuit 150 is placed in its track mode, the latch 164 is placed in its flow-through mode, and the input voltage $e_{i1}$ is applied to node $V_{i1}$ while the switch 32 is set to receive the input voltage $e_{i2}$ via input node $V_{i2}$. The output node 168 of the approximation circuit 160 approximates whatever control voltage is required by the transconductance converter 154 in order to bring the output voltage $V_o$ to approximately the first input voltage $e_{i1}$, and the error amplifier 40 supplies whatever voltage is necessary to compensate for any errors in that approximation.

In a second time period subsequent to the first time period, the track/hold unit 150 (Fig. 8) is placed in its hold mode and switch 32 is switched to receive $e_{i3}$ via node $V_{i3}$. For reasons described previously, the voltage of the output node $V_o$ during this second time period becomes equal to $e_o = e_{i1} - e_{i2} + e_{i3}$. Thus it can be seen that once again no precision components are required to form an accurate result, since any errors, including those introduced by inaccuracies in the resistor 20, by any DC offset in voltage reference follower 30, and by any non-linearity or DC offset in transconductance converter 154, are compensated by the error amplifier 40. Moreover, since the K = 1 voltage on the hold capacitor in track/hold 150 is minimized through the use of approximation circuit 160, K may be made large enough to thereby attenuate the effect of the hold step on the output voltage as previously explained. The only other error that does remain is the error due to the DC offset in the error amplifier 40.

The functions of many of the individual components used in Fig. 8 can be combined and/or divided into different functional blocks than those shown explicitly in Fig. 8. For example, the function of the attenuator 152 may be merged with that of the transconductance converter 154 simply by enlarging the channel widths of one of the two pairs of differential input transistor 180 and 182, or 184 and 186 (Fig. 9) by a factor of K relative to the other pair. Additionally, if that is done, track/hold unit 150 may be as simple as a series switch followed by a capacitor to ground; a voltage follower which might otherwise be needed in a track/hold to isolate the capacitor from any load can be omitted since the input to the transconductance amplifier already has a very high impedance. As another example, the approximation voltage at node 158 may be added to the voltage at node 156 by a separate low-precision summing amplifier, the result being coupled to a single control input of a transconductance amplifier more like that designated as 10 in Fig. 3. Other variations will be apparent to the reader.

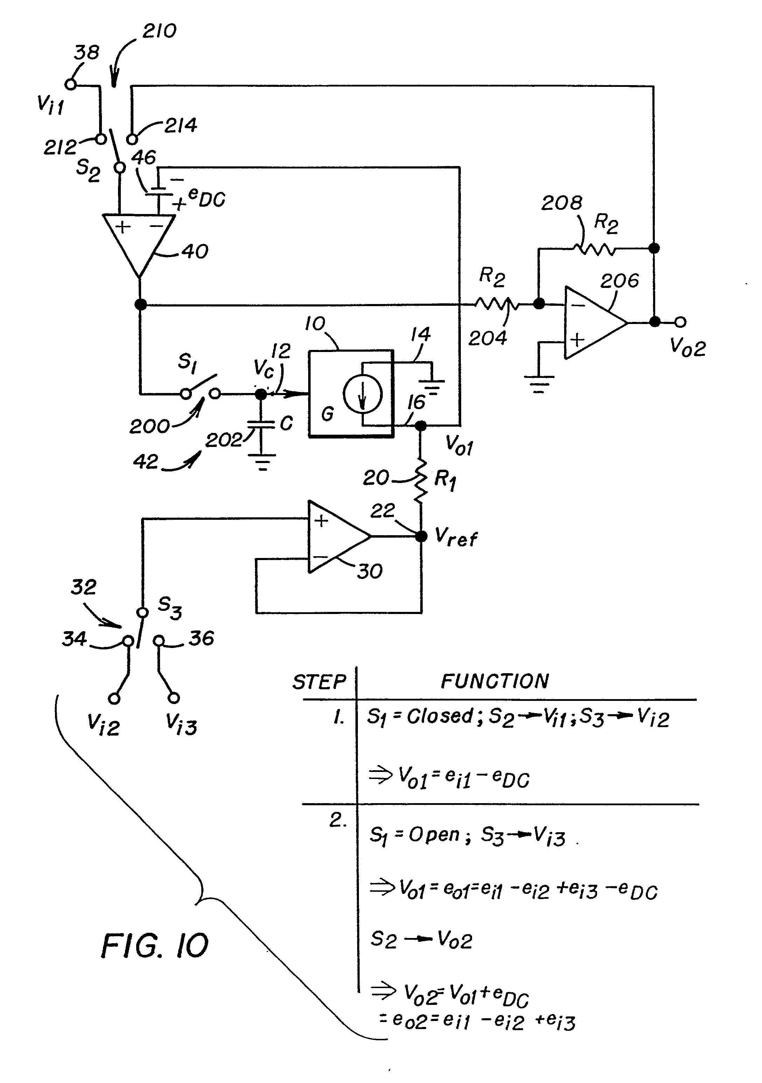

As previously mentioned, the only error which remains in the calculated output of either the circuit of Fig. 3 or the circuit of Fig. 8 is that due to the DC offset in error amplifier 40. This error too, can be cancelled through the use of a second stage as shown in Fig. 10. Approximation circuitry such as 160 (Fig. 8) is not shown in Fig. 10 or in the remainder of the present application, but it will be understood that such an approximation circuit can be added if desired.

The circuit of Fig. 10 includes the following elements which are also present in Fig. 3: error amplifier 40; track/hold 42 (shown as series switch 200 followed by capacitor 202 to ground in Fig. 10); single control input transconductance amplifier 10 with transfer characteristic G; resistor 20; voltage reference amplifier 30 with output node 22 and switch 32 for selecting between the $V_{i2}$ and $V_{i3}$ signal inputs. Control means 18 is present but is no longer shown in the diagrams in the interest of simplicity. These elements are all connected to each other in the same manner as they are in Fig. 3. Additionally in Fig. 10, the output of error amplifier 40 is connected through a resistor 204 to the inverting input of another operational amplifier 206. the output of which is also connected through a feedback resistor 208 to the inverting input of the amplifier 206. The non-inverting input of amplifier 206 is connected to ground, and the output of amplifier 206 forms a $V_{o2}$ output of the computational circuit. The values of resistors 204 and 208 may be, but are not necessarily, equal. Also, the non inverting input of error amplifier 40 in Fig. 10 is not connected directly to the $V_{i1}$ input node as it is in Fig. 3; instead it is connected to the common of a switch 210, one pole 212 of which is connected to the $V_{i1}$ input node. The other pole 214 of the switch 210 is connected to the output node $V_{o2}$. Finally, the DC offset in the voltage reference follower 30 is compensated in the final calculation at the $V_{o1}$ node 16, so it is omitted in the drawing of Fig. 10. A battery 46 representing the DC offset $e_{DC}$ of the error amplifier 40, however, is still shown.

In the first time period of the operation of the circuit of Fig. 10, the switch 200 is closed, the switch 32 is set to receive the $V_{i2}$ input and the switch 210 is set to receive the $V_{i1}$ input. The input voltages $e_{i1}$, $e_{i2}$ and $e_{i3}$ are applied to the respective nodes $V_{i1}$, $V_{i2}$ and $V_{i3}$. As explained previously, a voltage equal to $e_{i1} - e_{DC}$ appears during this first time period on the $V_{o1}$ node, and the voltage at the reference node 22 is $e_{i2}$ minus the DC offset of the reference follower 30.

In the second time period, switch 200 is opened and switch 32 is switched to receive the $e_{i3}$ input voltage from node $V_{i3}$. Regardless of the signal on the non-inverting input of error amplifier 40, as previously explained, the voltage on the node $V_{o1}$ will now equal $e_{o1} = e_{i1} - e_{i2} + e_{i3} - e_{DC}$.

Additionally during this second time period, however, the switch 210 is switched to pole 214 such that the non-inverting input of error amplifier 40 receives the voltage on the output node $V_{o2}$. The inverting input of the error amplifier 40 is still connected (through the symbolic battery 46) to the node $V_{o1}$. Since amplifier 206 is connected as an inverting buffer, the total feedback around the loop formed by error amplifier 40, inverting amplifier 206 and switch 210 is negative. Thus the error amplifier 40 will adjust its output voltage to whatever voltage is necessary to bring its inverting and non-inverting inputs to an equal voltage. Since the voltage on the node $V_{o1}$ during the second time period equals $e_{i1} - e_{i2} + e_{i3} - e_{DC}$ the voltage at the inverting input of error amplifier 40 will be $e_{i1} - e_{i2} + e_{i3}$.

In effect, the roles of the two inputs of the error amplifier are reversed during this second time period: in the first time period, the non-inverting input was constant and the error amplifier 40 adjusted its output to bring the inverting input into equality, whereas in the second time period, the inverting input is constant and the error amplifier 40 adjusts its output to bring the non-inverting input into equality. Thus, whereas the DC offset $e_{DC}$ of error amplifier 40 was subtracted during the first time period, it is added during the second. The error amplifier 40 during this second time period therefore forces the output node $V_{o2}$ to the voltage $e_{o2} = e_{i1} - e_{i2} + e_{i3}$ without any error due to DC offsets. Moreover, it will be appreciated that errors in the accuracy of resistors 204 and 208, and errors due to the DC offset of amplifier 206, are all compensated by the error amplifier 40.

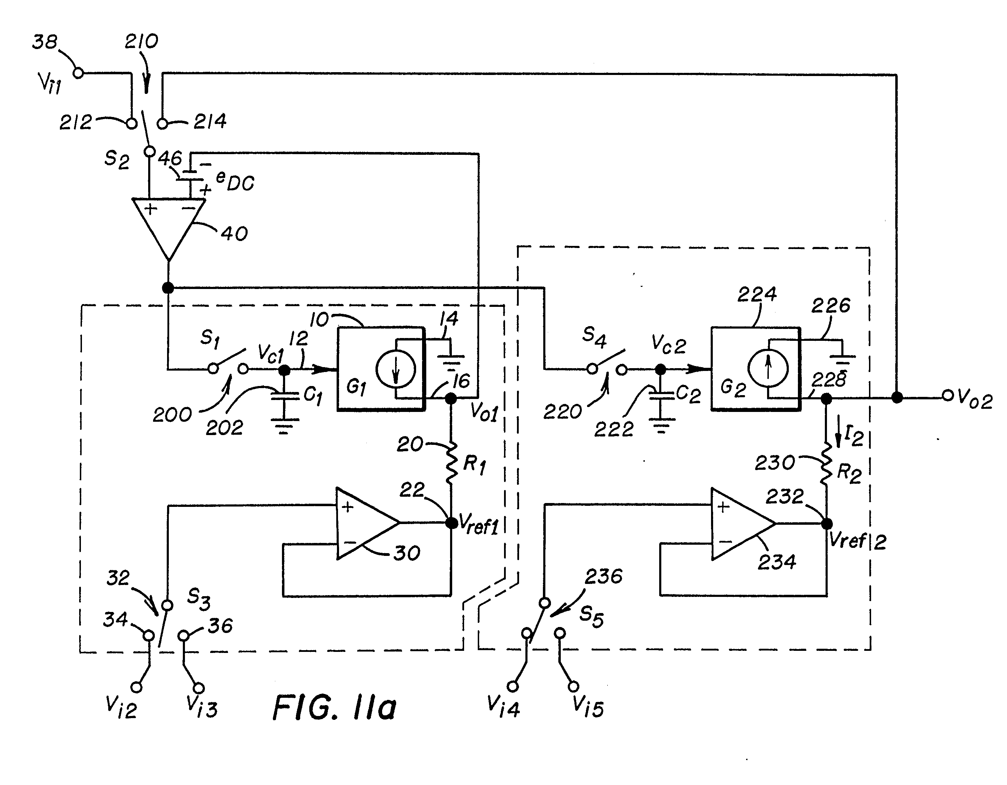

Fig. 11a shows another embodiment of the invention which cancels the DC offset in the error amplifier 40 and also provides the additional flexibility of two new input nodes $V_{i4}$ and $V_{i5}$. If analog input voltages $e_{i1}$, $e_{i2}$, $e_{i3}$, $e_{i4}$ and $e_{i5}$ are applied to the input nodes $V_{i1}$, $V_{i2}$, $V_{i3}$, $V_{i4}$ and $V_{i5}$, then after the threestep operation detailed in Fig. 11b the output node $V_{o2}$ will carry a voltage $e_{o2} = e_{i1} - e_{i2} + e_{i3} - e_{i4} + e_{i5}$. This analog calculation is highly precise, compensating for all DC offsets and all component value inaccuracies present in the circuit.

Referring to Fig 11a, it includes the following elements, connected as they are in Fig. 10: error amplifier 40, switch 200, capacitor 202, transconductance converter 10, resistor 20, reference node 22, reference voltage follower 30, and switch 32. The non-inverting input of error amplifier 40 is connected to the common of switch 210, and when switch 210 is connected to pole 212, the non-inverting input of error amplifier 40 is connected to the input node $V_{i1}$. Further as in Fig. 10, the other pole 214 of the switch 210 in Fig. 11a is connected to the output node $V_{o2}$ of the analog computational circuit. Instead of the unity gain inverting amplifier 206 with its resistors 204 and 208 as shown in Fig. 10, the second stage of Fig. 11a comprises essentially a repeat of the first stage. Thus, the output of error amplifier 40 is connected to one terminal of a switch 220, the other terminal of which is coupled through a capacitor 222 to ground and also forms the voltage control input of a transconductance amplifier 224. The transconductance converter 224 generates a current $I_2$ from one of its current path output terminals 226 to the other 228, and the terminal 228 is connected to the output node $V_{o2}$ of the analog computational circuit of Fig. 11a. The terminal 228 is also connected through a resistor 230 to a $V_{ref2}$ node 232, which is connected to the output of a voltage follower 234. The inverting input of the voltage follower 234 is connected to the $V_{ref2}$ node 232, and the non-inverting input of follower 234 is connected to the common of a switch 236. The two poles of switch 236 are connected, respectively, to a $V_{i4}$ input node and a $V_{i5}$ input node.

The transconductance amplifier 224 may be similar in design to the transconductance amplifier 10, except that it should have an inverting output in order to maintain a negative sign in the feedback loop consisting of error amplifier 40, transconductance amplifier 224 and switch 210. Advantageously, $G_2 = 1/R$. However, inaccuracies here, as well as inaccuracies in the value of resistor 230 and any DC offset in follower 234, are all compensated by the error amplifier 40. In fact, $G_2$ need not even be linear, as long as it is decreasing when $G_1$ is increasing.

The operation of the analog computational apparatus shown in Fig. 11a is similar to that of the apparatus shown in Figs. 3 and 10 for the first two steps. In particular, the first step takes place during a first time period in which switch 200 is closed, switch 210 is set to connect the non-inverting input of error amplifier 40 to the $V_{i1}$ input of the apparatus, and switch 32 is set to connect the non-inverting input of follower 30 to the $V_{i2}$ input of the apparatus. The setting of switches 220 and 236 in the second stage does not matter during this first time period, a beneficial aspect of the apparatus which is explained in more detail below.

As with the previously described embodiments, during the second time period switch 200 is opened and switch 32 is set to connect the non-inverting input of reference amplifier 30 to the $V_{i3}$ input of the apparatus. Regardless of the setting of switch 210 at this time, the node $V_{o1}$ becomes equal to a first calculated voltage $e_{o1}$. The voltage $e_{o1}$ is "substantially" equal to $e_{i1} - e_{i2} + e_{i3}$ if the DC offset of error amplifier 40 is small, where $e_{i1}$, $e_{i2}$ and $e_{i3}$ are input voltages applied to the nodes $V_{i1}$, $V_{i2}$ and $V_{i3}$, respectively. The voltage $e_{o1}$ is exactly equal to $e_{i1} - e_{i2} + e_{i3} - e_{DC}$.

Also during the second time period, switch 220 in the second stage is closed and switch 210 is set to connect the non-inverting input of error amplifier 40 to the output node $V_{o2}$. The output of error amplifier 40 is no longer connected to the first stage of the apparatus of Fig. 11a, since the switch 200 is open. Thus, the error amplifier 40 now adjusts its output voltage to whatever voltage is required to bring the voltage at output node $V_{o2}$ into agreement with the fixed voltage at node $V_{o1} + e_{DC}$. Thus, the voltage at the $V_{o2}$ node will during this second time period be exactly equal to $e_{i1} - e_{i2} + e_{i3}$. As with the circuit of Fig. 10, in essence, the voltage which was affected by the DC offset in error amplifier 40 is now used oppositely in the error amplifier 40 to cancel off the DC offset.

Also during this second time period, switch 236 is set to connect the non-inverting input of the voltage reference follower 234 to the $V_{i4}$ node, thereby bringing the $V_{ref2}$ node 232 to the input voltage $e_{i4}$ which is applied to the input node $V_{i4}$. (Actually, the DC offset of follower 234 affects the voltage at the $V_{ref2}$ node 232, but as with the first stage of the apparatus, this DC offset is subsequently cancelled.) The current $I_2$ produced through the resistor 230 by the transconductance converter 224 during this second time period is therefore such that $I_2 R_2 = (e_{i1} - e_{i2} + e_{i3}) - e_{i4}$.

The third step of the operation of the apparatus of Fig. 11a takes place during a third time period subsequent to the second time period. In the third time period, switch 220 is opened and switch 236 is set so that the non-inverting input of follower 234 is connected to the $V_{i5}$ input of the apparatus, which receives an input voltage $e_{i5}$. The settings of switches 210, 200 and 32 during the third time period do not matter. Since the voltage at the control input of transconductance converter 224 is held constant during this third time period by the capacitor 222, the current $I_2$ through the resistor 230 also remains constant and equal to the current which was present in the resistor 230 during the second time period. Also, the voltage $V_{ref2}$ at node 232 is equal to $e_{i5}$. Thus the voltage at the output node $V_{o2}$ during the third time period will equal $I_2 R_2 + e_{i5}$, which is exactly equal to $e_{i1} - e_{i2} + e_{i3} - e_{i4} + e_{i5}$.

This analog computation is extremely accurate regardless of any inaccuracies in resistor values, DC offsets in the operational amplifiers, DC offsets and non-linearities in the transconductance converters 10 and 224 and insertion losses due to the switches 200 and 220 in the track/hold portions of the circuits. Moreover, inaccuracies due to track/hold steps and/or capacitor voltage droop may be significantly reduced through the use of the approximation technique explained with reference to Figs. 6-8. In this connection, it should be noted that the same approximation circuit whose output would connect to a second control input of transconductance converter 10 may also have its output connected to a second input of transconductance converter 224 since the voltage held on the capacitor 222 in the second and third time periods should be approximately equal to the voltage held on capacitor 202 in the first and second time periods. This is especially true if $e_{i4}$ is close to $e_{i2}$ and $G_2$ is approximately equal to $-G_1$. Moreover, since the ADC/latch/DAC implementation of an approximation circuit may typically be much faster than the operation of the remainder of the analog arithmetic unit, a single ADC/latch/DAC may be multiplexed for separate use with both stages of the arithmetic unit and/or with other stages of other arithmetic units which may be integrated onto the same chip.

The apparatus shown in Fig. 11a forms an analog computational cell having five analog inputs and one analog output. It is autonomous enough to find use in many different contexts related to analog computing, analog signal processing and other types of analog signal conditioning. For example, the cell of Fig. 11a may form the core of a general-purpose analog computer, much like a digital ALU forms the core of a digital computing device. Thus, the cell of Fig. 11a may be integrated onto a chip in conjunction with a plurality of individual memory cells such as that shown in Fig. 7, and in conjunction with a digital sequencer of some form to control the various switches.

In this connection it should be noted that though in the general form the cell completes an analog computation during the third time period, the operation of the cell may be pipelined such that the third time period of one operation overlaps with the first time period of the next operation. This is because, as previously mentioned, the settings of the various switches in the first stage of the cell do not affect the result when an operation is in its third time period, and the settings of the various switches in the second stage of the cell do not affect the result of an operation which is in its first time period.

Moreover, it should be noted that the result of a calculation at the $V_{o2}$ node need not always be returned to the analog memory bank before it is reused in the next calculation since the sequencing apparatus can, for example, connect the $V_{o2}$ node directly to either of the input nodes $V_{i1}$ or $V_{i2}$ which are active during the first time period of the next operation. In fact, the connection from $V_{o2}$ to the non-inverting input of error amplifier 40 already exists in the cell via the switch 210.

The cell of Fig. 11a may also be used in various stand-alone capacities, to perform various specific analog computations. Several examples of these are set forth below. In the drawings accompanying these examples, a cell is depicted as a box having five analog inputs and one analog output, all generally located around the box at about the same relative positions that they appear in the diagram of Fig. 11a. If the input nodes $V_{i4}$ and $V_{i5}$ are omitted in a drawing, a cell such as that shown in Fig. 10 may be substituted for that shown in Fig. 11a. Alternatively, a cell such as that shown in Fig. 11a may be used, with both the $V_{i4}$ and $V_{i5}$ input nodes connected to ground. Other simplified cell structures may be used or the various degenerate cases.

## Analog multiplication by 2.

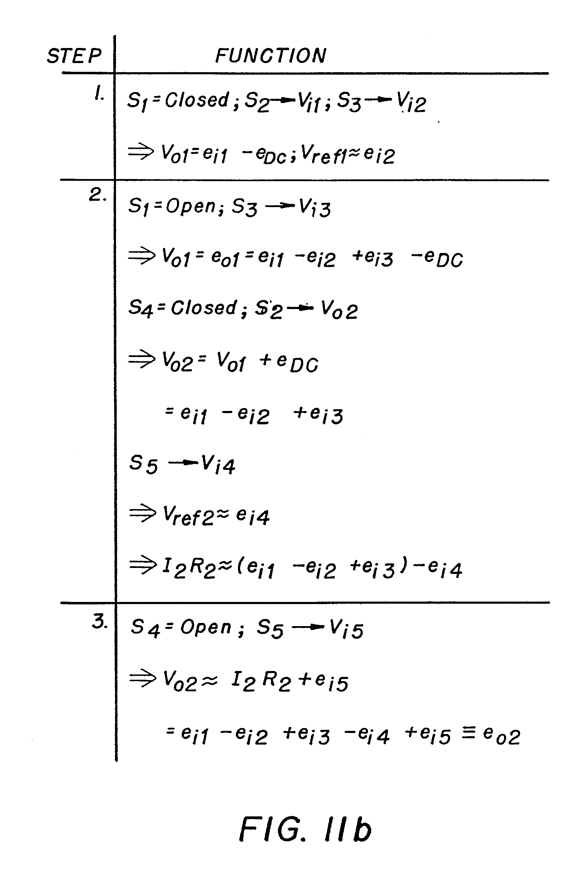

Fig. 12 shows a connection for using the a cell 300 to perform accurate voltage doubling. Very simply, the input voltage is connected to both the $V_{i1}$ and $V_{i3}$ nodes, with the $V_{i2}$, $V_{i4}$ and $V_{i5}$ nodes all connected to ground. The output of the cell 300 is the output of the voltage doubler. Since the output voltage of the cell 300 equals the sum of the voltages at nodes $V_{i1}$, $V_{i3}$ and $V_{i5}$, minus the sum of the voltages at input nodes $V_{i2}$ and $V_{i4}$, and

since the voltages at input nodes $V_{i2}$, $V_{i4}$ and $V_{i5}$ are all zero, the cell 300 effectively adds the input voltage to itself to generate twice the input voltage.

It will be apparent that the input voltage could instead be connected to nodes $V_{i1}$ and $V_{i5}$, or to nodes $V_{i3}$ and $V_{i5}$, instead of to nodes $V_{i1}$ and $V_{i3}$, with the same results. It will also be apparent that extremely accurate voltage tripling can be performed by connecting the same input voltage to all of the nodes $V_{i1}$, $V_{i3}$ and $V_{i5}$, with nodes $V_{i2}$ and $V_{i4}$ connected to ground. Accurate voltage inversion can also be performed, as can accurate voltage multiplication by minus 2.

## Analog multiplication by fixed integer n.

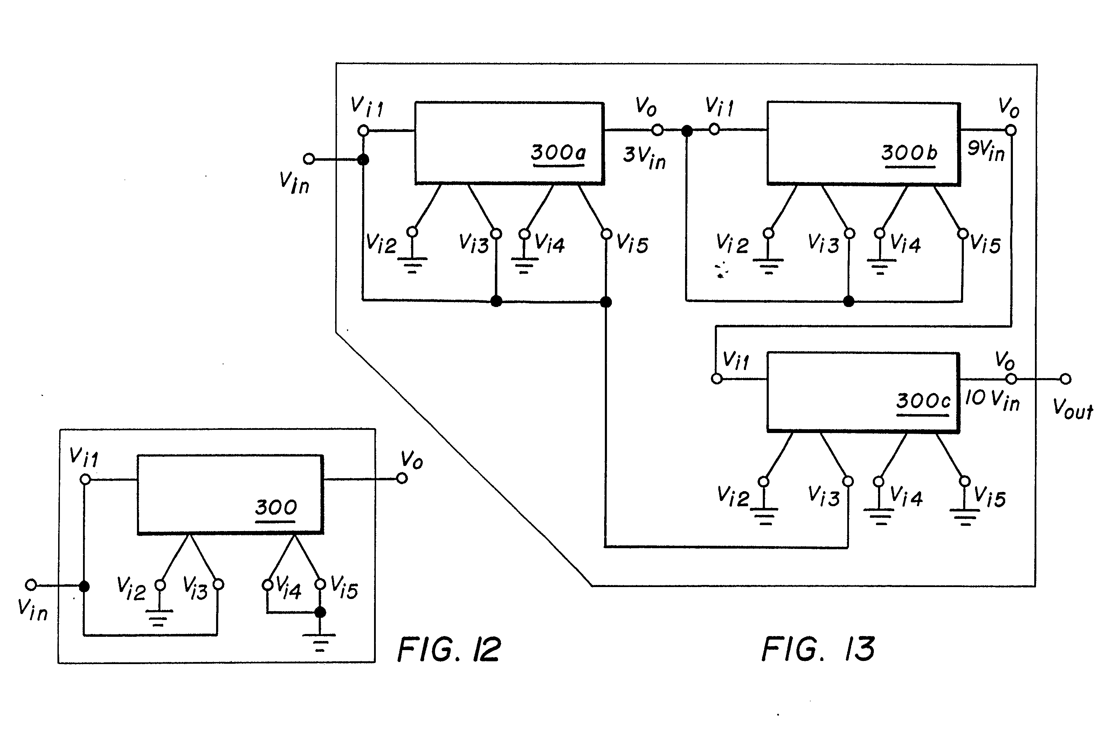

Cells such as 300 can be cascaded as desired to generate any fixed integer multiple of an input voltage. Fig. 13, for example, shows how three cells 300a, 300b and 300c may be cascaded to multiply an input voltage by a fixed integer 10. The input voltage is connected to the $V_{i1}$, $V_{i3}$ and $V_{i5}$ inputs nodes of the first cell 300a, and the output of cell 300a is connected to the $V_{i1}$, $V_{i3}$ and $V_{i5}$ inputs of the next cell 300b. The output of cell 300b is connected to the $V_{i1}$ input of the third cell 300c, and the input node $V_{i3}$ of the third cell 300c is connected to the input voltage. All other input nodes for the three cells are tied to ground.

The circuit of Fig. 13 completes a multiplication by 10 at the end of the sixth time period. In the first, second and third time periods, cell 300a generates on its output a voltage equal to three times the input voltage. This result is available during the third time period for use by the next cell 300b. Thus, cell 300b generates during the third, fourth and fifth time periods a voltage equal to nine times the input voltage. Since this voltage is provided as one input of the cell 300c and the input voltage is provided as another non-inverting input to cell 300c, cell 300c generates on its output during the fifth and sixth time periods a voltage equal to 9 + 1 = 10 times the input voltage. It will be apparent that many other interconnections between three or more cells will work to generate ten times the input voltage.

## Analog multiplication by a variable integer n.

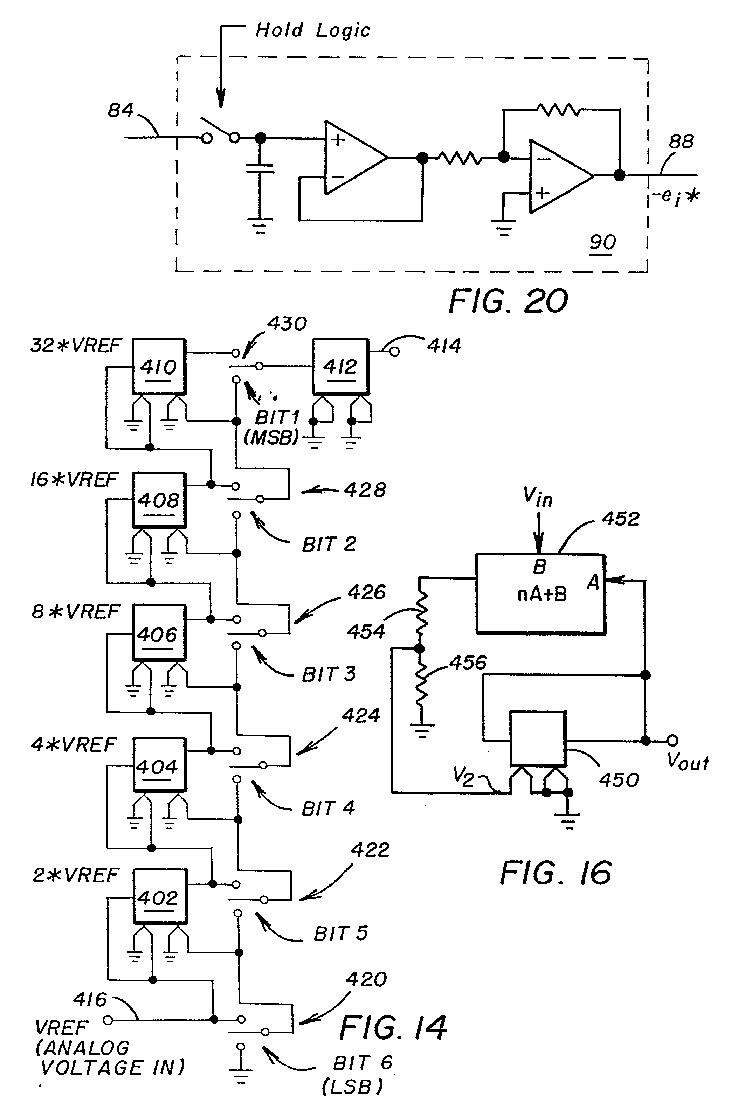

Fig. 14 shows how six cells 402, 404, 406, 408, 410 and 412 may be interconnected in order to generate at a product node 414 a precision voltage equal to n times the voltage at an input node 416, where n is specified as a 6-bit digital input term. Essentially, such a circuit constitutes a 6-bit DAC. As with the circuit of Fig. 13, the interconnection shown in Fig 14 is only one of many variations which would operate correctly.

In Fig. 14, the analog voltage input node 416 is connected to the first and third inputs of cell 402, and also to the normally open terminal of an SPDT switch 420. As used in this description, the normally closed terminal of an SPDT switch is the terminal which the switch couples to its common terminal when the control input is inactive, and the normally open terminal of an SPDT switch is the terminal which the switch couples to its common terminal when the control input of the switch is active. The normally closed terminal of switch 420 is connected to ground, and the common terminal is connected to the fifth input of cell 402 and also to the normally closed terminal of another SPDT switch 422.

The output of cell 402 is connected to the normally open terminal of switch 422, and also to the first and third inputs of cell 404. The common terminal of switch 422 is connected to the fifth input of cell 404, as well as to the normally closed input of an SPDT switch 424.

The output of cell 404 is connected to the normally open terminal of switch 424, and also to the first and third inputs of cell 406. The common terminal of switch 424 is connected to the fifth input of cell 406, as well as to the normally closed terminal of an SPDT switch 426.

The output of cell 406 is connected to the normally open terminal of switch 426, and also to the first and third inputs of cell 408 The common terminal of switch 426 is connected to the fifth input of cell 408, as well as to the normally closed input of another SPDT switch 428.

The output of cell 408 is connected to the normally open terminal of switch 428, and is also connected to the first and third inputs of cell 410. The common terminal of switch 428 is connected to the fifth input of cell 410, as well as to the normally closed terminal of another SPDT switch 430.

The output of cell 410 is connected to the normally open terminal of switch 430, and the common terminal of switch 430 is connected to the first input of a cell 412. The second, third, fourth and fifth inputs of cell 412, as well as the second and fourth inputs of each of the cells 402, 404, 406, 408 and 410, are all connected to ground. The output voltage is taken from the output 414 of the cell 412. The six bits of the input term n are connected to the control inputs of the six switches 420, 422, 424, 426, 428 and 430, respectively, the least-significant bit (bit 6) controlling the switch 420 and the most-significant bit (bit 1) controlling the switch 430.

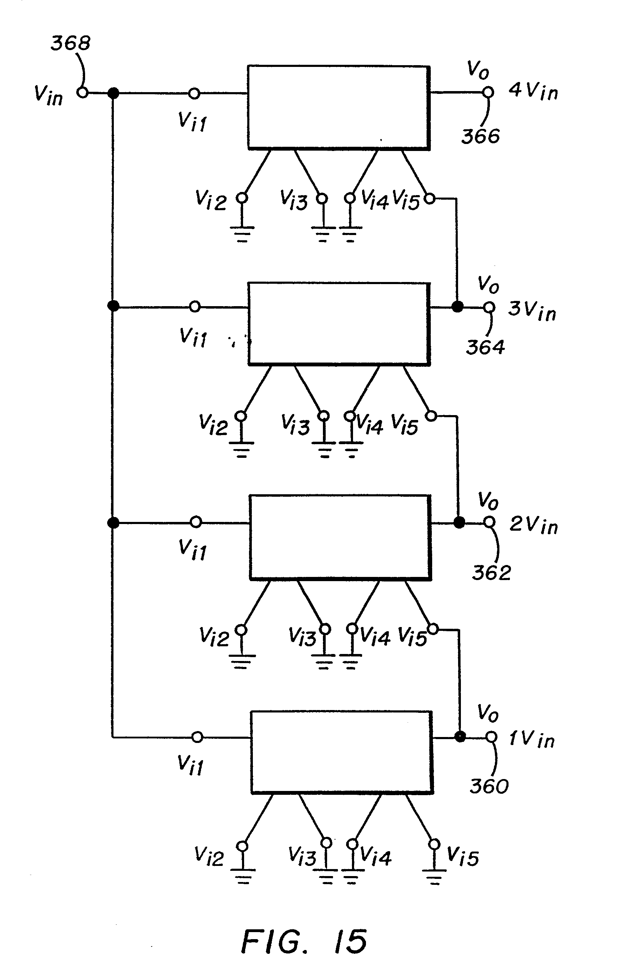

The apparatus of Fig. 14 requires several clock cycles to complete each multiplication, since it is serial in nature. A parallel construction for analog multiplication by an arbitrary integer n is shown in Fig. 15. The circuit of Fig. 15 generates at nodes 360, 362, 364 and 366, respectively, one, two, three and four times the voltage at the input node 368. These values are all available during the third time period, and an appropriate switching network may be provided for the outputs. It will be apparent that any number of cells may be cascaded in this manner to have available to the switching network any desired maximum multiplier n.

### Integrator.

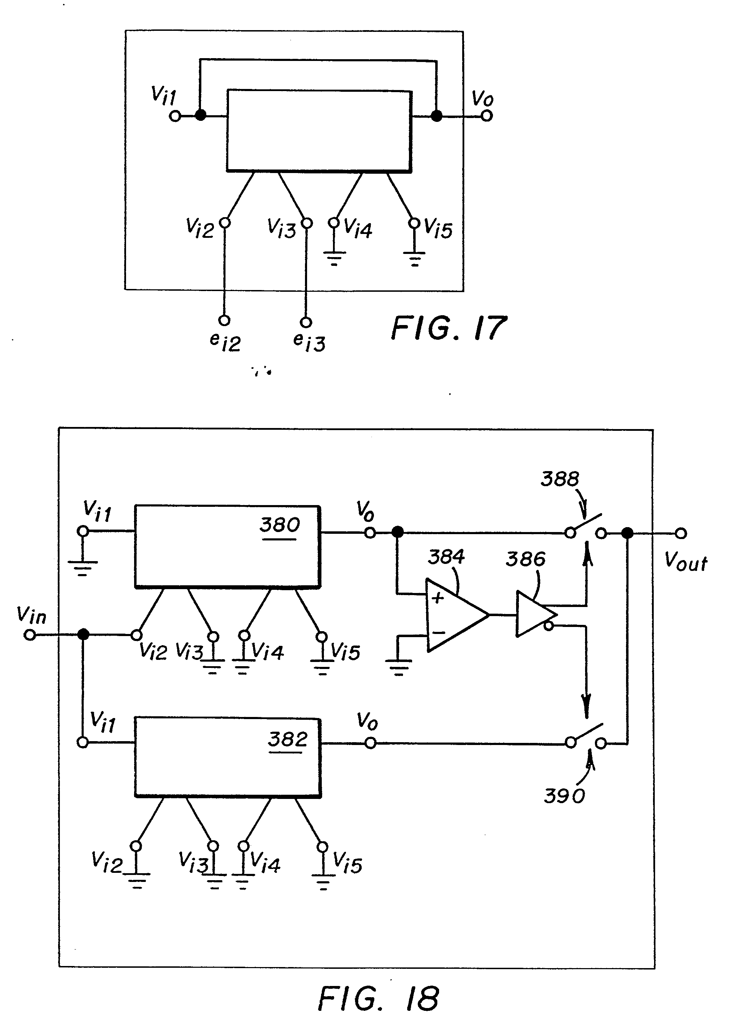

As shown in Fig 17, a cell may be connected to perform integration merely by connecting the output node back to the first input node $V_{i1}$. The fourth and fifth inputs nodes $V_{i4}$ and $V_{i5}$ are connected to ground, for example, and the second and third inputs nodes $V_{i2}$ and $V_{i3}$ are connected to receive input voltages $e_{i2}$ and $e_{i3}$. It can be seen that connected this way, the output voltage will increase by $(e_{i3} - e_{i2})$ after each pair of clock cycles.

Note that, referring back to Fig. 11a, the external connection between the output node and the first input node $V_{i1}$ is not even necessary since such a connection is already provided through switch 210. All that is needed to operate the cell of Fig. 11a as an integrator is to leave the switch 210 connected to terminal 214 such that the output node $V_{o2}$ (Fig. 11a) is always connected to the non-inverting input of error amplifier 40.

### Integer divider.

Using an integrator with an integer multiplier in its feedback loop, cells according to the invention may be interconnected to perform integer division of an analog input signal, either by a fixed or variable integer n. A topology which will perform integer division is shown in Fig. 16. It comprises a cell 450 having its first input connected to its output, and its third, fourth and fifth inputs connected to ground. The output of the cell 450 forms the output $V_{out}$ of the divider circuit, and is also connected to an A input of a computational block 452. The computational block 452 also has a B input coupled to receive the analog input voltage $V_{in}$, and an output connected through a series pair of resistors 454 and 456 to ground. The junction between the resistors 454 and 456 is connected to the second input of cell 450. The computational block 452 is constructed using one or more cells according to the invention, arranged and connected so that its output voltage equals nA + B. For example, if n = 2 then the computational block 452 may simply be a single cell according to the invention, having its first and third inputs connected to the A input of the computational blook 452, its fifth input connected to the B input of computational block 452, and its second and fourth inputs connected to ground. Resistors 454 and 456 form a resistor divider for the purpose of attenuating the feedback signal in order to decrease loop gain for stability. The values of these resistors define an attenuation constant K, which need not be precise.

In operation, the cell 450 provides as $V_{out}$ a voltage equal to the inverse of the voltage $V_2$ that was on its second input during the previous pair of clock cycles. $V_{out}$ is provided to the computational block 452, which generates the voltage $nV_{out} + V_{in}$ on its output. After passing through the resistor divider 454/456, the voltage which reaches the second input of cell 450 is $K(nV_{out} + V_{in})$. The tendency of the circuit of Fig. 16, therefore, is to force the voltage $V_2$ to zero. From the equation $V_2 = K(nV_{out} + V_{in}) = 0$, it can be seen that the output voltage $V_{out}$, will converge on a voltage equal to $V_{out} = -V_{in}/n$.

Absolute value generator.

Cells according to the invention may also be used to generate the absolute value of an input signal. Referring to Fig. 18, a circuit to accomplish this includes two cells 380 and 382, an analog comparator 384, a digital buffer 386 and two switches 388 and 390. The input signal is connected to the second input node $V_{i2}$ of the cell 380, and also to the first input node $V_{i1}$ of the cell 382. The other four input nodes of each of the two cells 380 and 382 are each connected to ground, so that the output node of cells 382 will after two time periods carry the input voltage identically, and the output of cell 380 will after two time periods carry the negative of the input voltage. The output node of the cell 380 is connected to the non-inverting input of comparator 384, the inverting input of which is connected to ground. The output of comparator 384 is connected to digital buffer 386 which has both an inverting and a non-inverting output. The output nodes of cells 380 and 382 are also coupled through the respective switches 388 and 390 to the output node of the absolute value generator. The non-inverting output of buffer 386 controls switch 388 (when the buffer output is active the switch 388 is closed) and the inverting output of buffer 386 controls switch 390.

In operation, the output of comparator 384 will be high when the voltage output of cell 380 is greater than zero, and it will be low otherwise. This means that after the signal passes through buffer 386, switch 388 will be closed when the output of cell 380 is greater than zero and switch 390 will be closed when the output of cell 380 is less than zero. Since the outputs of cells 382 and 380 carry equal but opposite voltages, it can be seen that the switches 388 and 390 effectively select for the output of the absolute value generator whichever of the two output voltages, that of cell 380 or that of cell 382, is greater than zero. Thus the circuit generates the absolute value of the input voltage.

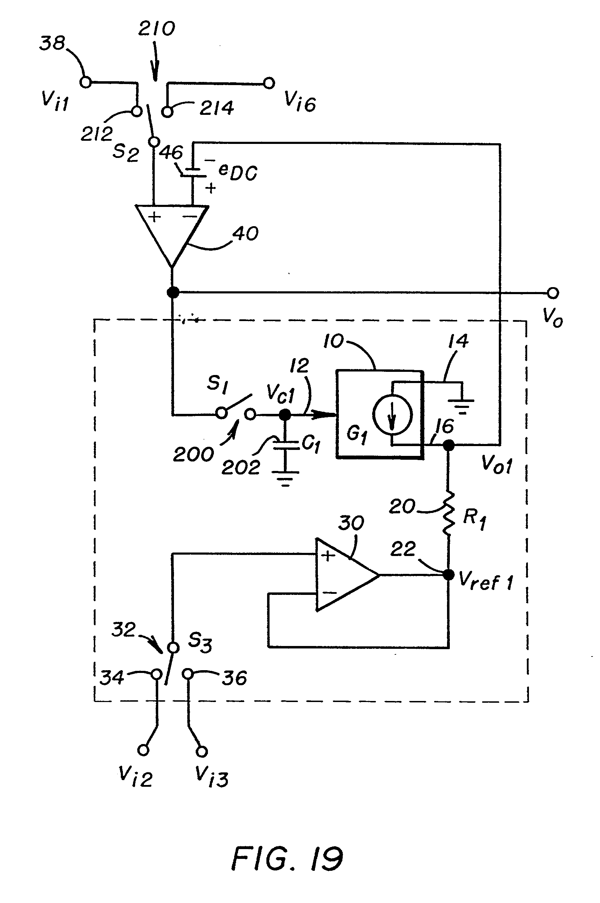

The absolute value generator of Fig. 18 may be slightly inaccurate because comparator 384 has a non-zero DC offset. Fig. 19 shows how the principles of the present invention can be used to design an analog comparator that has zero offset. The figure is exactly the same as that of Fig. 11a, except that the entire second stage has been deleted. The terminal 214 of switch 210, instead of being connected to the output voltage of the second stage, is now provided as a sixth voltage input terminal $v_{i6}$. The comparator output $V_o$ is taken from the output of error amplifier 40.

In operation, during the first time period, the track/hold 200/202 is placed in its track mode, the switch 210 is switched to the terminal 212, and the switch 32 is switched to the terminal 34. A current $I_1$ is therefore generated through resistor 20 such that $I_1R_1 = V_{i1} - V_{i2} - e_{DC}$ (the offset of op amp 30 being ignored). In the second time period the track/hold 200/202 is placed in its hold mode, thereby permitting the output of error amplifier 40 to float freely. Switch 210 is connected to terminal 214, and switch 32 is connected to terminal 36. Error amplifier 40 now acts as a high-gain comparator, comparing $V_{i6}$ to $e_{DC}$ plus the voltage at node $V_{o1}$. Since the voltage at node $V_{o1}$ is now equal to $V_{i1} - V_{i2} + V_{i3} - e_{DC}$, the offset of error amplifier 40 cancels and the comparator output voltage $V_o$ thereby carries a voltage dependent upon a highly accurate comparison of the voltage $V_{i6}$ with the voltage $V_{i1} - V_{i2} + V_{i3}$. Of course, the comparator of Fig. 19 can be further simplified by deleting reference amplifier 30 and connecting the node 22 directly to ground. This would eliminate inputs $V_{i2}$ and $V_{i3}$, and provide an output $V_o$ which accurately compares the voltages $v_{i1}$ and $v_{i6}$.

Alternative Embodiment For Fig. 2.

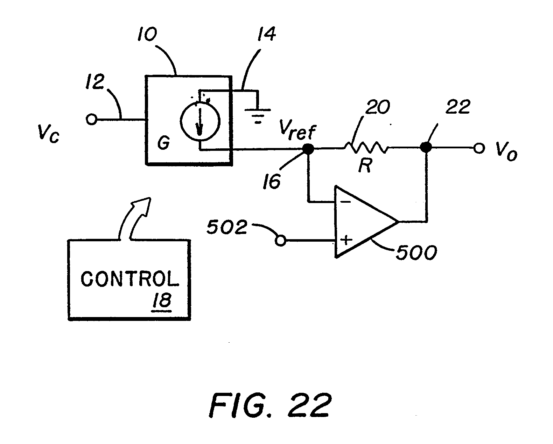

As previously explained, the apparatus of Fig. 2 shows core features of apparatus for performing analog computation. A slightly different embodiment is shown in Fig. 22. It comprises a transconductance converter 10, having a control input 12 and two current path terminals 14 and 16. Like the apparatus in Fig. 2, the current path terminal 16 of the apparatus of Fig. 22 is coupled through a resistor 20 to a node 22. Unlike the circuit of Fig. 2,

however, the output $V_o$ is taken from node 22, not from node 16

The apparatus of Fig 2, as previously explained, is operated by, in a first time period, applying a second analog input voltage at node 22 and adjusting the current output of the transconductance converter 10 until the current I passing through the resistor 20 was such that the voltage at node 16 was substantially equal to a first analog input voltage. In a second time period, the current I through the resistor 20 was held constant while the voltage at node 22 was changed to a third analog input voltage. The node 16 then held the desired output voltage.

In Fig. 22, by contrast, in the first time period the second analog input voltage is applied at node 16 while the current through the resistor 20 is adjusted until the voltage at node 22 is approximately equal to the first analog input voltage. In the second time period the current through the resistor 20 is held constant while the voltage at node 16 is changed to the third analog input voltage. Thus, whereas in Fig. 2 the resistor terminal farthest from the transconductance converter 10 was the reference voltage node $V_{ref}$ while the resistor terminal nearest the transconductance converter 10 was the output node $V_o$, in Fig. 22 the resistor terminal nearest the transconductance converter 10 is the reference node $V_{ref}$ while the resistor terminal farthest from the transconductance converter 10 is the output node $V_o$.

Fig. 22 also shows an operational amplifier 500 having its inverting input connected to node 16 and its output connected to node 22. The non-inverting input 502 of the operational amplifier 500 is a high impedance terminal for applying the second and third analog input voltages at the appropriate times. Whatever voltage is applied to terminal 502 is transferred to the $V_{ref}$ node 16 due to the operation of operational amplifier 500 in adjusting its output voltage in order to bring its two input voltages into equality.

The circuit of Fig. 22 has a low impedance output, making it suitable for driving DC loads. On the other hand, the circuit of Fig 22 inserts another amplifier into the forward control loop. This makes stabilizing the loop more difficult, which in turn slows the circuit. A designer can choose whichever embodiment better fits the application. Like the voltage follower 30 (Fig. 3), any DC offset introduced into the output voltage by the operational amplifier 500 (Fig. 22) during the first time period is cancelled during the second time period.

The invention has been described with respect to particular embodiments thereof, and it will be understood that numerous variations and modifications will be apparent to a person of ordinary skill after reading the present specification. For example, whereas the embodiments described herein all have voltage inputs and outputs, a person of ordinary skill would know that the principles of the invention may be implemented using other analog quantities such as current. As another example, where voltage signals are generated and used at different parts of the circuits desoribed herein, current signals may often be substituted and vice versa. As another example, though some of the embodiments desoribed herein use MOS transistors and MOS op-amps, it will be understood that bipolar and combined MOS/bipolar implementations are also possible, as are implementations in other technologies. These and other variations are intended to be within the scope of the claims.

## Claims

1. Analog arithmetic apparatus for generating an analog output signal $a_o$ having a value given by the value of a first analog input signal $a_{i1}$ minus the value of a second analog input signal $a_{i2}$ plus the value of a third analog input signal $a_{i3}$, comprising: computational means for use with first and second computational means analog input signals each having a value, and for generating a computational means analog output signal having a value equal to said value of said second computational means analog input signal plus some single valued function of said value of said first computational means analog input signal; and control means for, in a first time period, determining an analog signal $a_c$ having a value such that said computational means generates as said computational means analog output signal a signal having a value substantially equal to said value of said signal $a_{i1}$ when said signal $a_{i2}$ is provided as said second computational means analog input signal and said signal $a_c$ is provided as said first computational means analog input signal, and for, in a second time period subsequent to said first time period, providing said signal $a_c$ as said first computational means analog input signal and providing said signal $a_{i3}$ as said second computational means analog input signal, said output signal $a_o$ being generated as said computational means analog output signal during said second time period.

2. Apparatus according to claim 1, wherein said computational means comprises: means for generating a current I as a function of the value of said first computational means analog input signal, and means for generating as said computational means analog output signal a signal having a value equal to a voltage valued function of said second computational means analog input signal plus a voltage valued function of said current I.

3. Apparatus according to claim 1, wherein said signals $a_{i1}$, $a_{i2}$, $a_{i3}$, $a_o$, said second computational means analog input signals and said computational means analog output signal are all voltage signals, and wherein said computational means comprises: adjustable current source means for generating a current I as a function of the value of said first computational means analog input signal; and output generating means for generating as said computational means analog output signal a signal having a voltage equal to the voltage of said second computational means analog input signal plus a voltage valued function of said current I.

4. Apparatus according to claim 3, wherein said output generating means comprises: a resistor having first and second terminals, said first terminal of said resistor being coupled to receive said current I; and voltage reference means for applying said voltage of said second computational means analog input signal to said second terminal of said resistor.

5. Apparatus according to claim 4, wherein said voltage reference means comprises: a voltage follower having an output coupled to said second terminal of said resistor and further having an input; and means for coupling to said input of said voltage follower said voltage of said $a_{i2}$ analog input signal during said first time period and said voltage of said $a_{i3}$ analog input signal during said second time period.

6. Apparatus according to claim 3, wherein said output generating means comprises: a resistor having first and second terminals, said first terminal of said resistor being coupled to receive said current I; and voltage reference means for applying said voltage of said second computational means analog input signal to said first terminal of said resistor.

7. Apparatus according to claim 6, wherein said voltage reference means comprises: an operational amplifier having first and second inputs and an output, said first input of said operational amplifier being coupled to said first terminal of said resistor and said output of said operational amplifier being coupled to said second terminal of said resistor; and means for coupling to said second input of said operational amplifier said voltage of said $a_{i2}$ analog input signal during said first time period and said voltage of said $a_{i3}$ analog input signal during said second time period.

8. Apparatus according to claim 1, wherein said control means comprises: means for providing as said second computational means analog input signal said signal $a_{i2}$ during said first time period; feedback means for providing a control signal, having a value, as said first computational means analog input signal and adjusting said value of said control signal during said first time period until said value of said computational means analog output signal substantially equals said value of said signal $a_{i1}$, said signal $a_c$ being determined as said control signal when said value of said computational means analog output signal substantially equals said value of said signal $a_{i2}$; means for holding said signal $a_c$ as said first computational means analog input signal during said second time period; and means for providing as said second computational means analog input signal said signal $a_{i3}$ during said second time period.

9. Apparatus according to claim 8, wherein said feedback means comprises an error amplifier having a first input coupled to receive said signal $a_{i1}$ during said first time period, a second input coupled to receive said computational means analog output signal during said first time period and an output for providing said control signal, said error amplifier having a DC offset which affects the accuracy of said analog output signal $a_o$, said apparatus further comprising means for canceling the effect on $a_o$ of said DC offset subsequent to said first time period.

10. Analog arithmetic apparatus having a $V_{o1}$ node, for generating at said $V_{o1}$ node an output voltage $e_{o1}$ substantially equal to $e_{i1} - e_{i2} + e_{i3}$, where $e_{i1}$, $e_{i2}$ and $e_{i3}$ are input voltages, comprising: first reference voltage supply means having an output node $V_{ref1}$, for holding said $V_{ref1}$ node at a second reference voltage ($e_{i2} + e_{DC1}$) during a first time period and at a third reference voltage ($e_{i3} + e_{DC1}$) during a second time period subsequent to said first time period, $e_{DC1}$ being a constant voltage offset or zero; a first resistor coupled between said $V_{o1}$ node and said $V_{ref1}$ node, said first resistor having first and second terminals; and first current control means for establishing in said first resistor a first current $I_1$ such that the voltage of said $V_{o1}$ node at the end of said first time period substantially equals $e_{i1}$, and for maintaining said first current $I_1$ in said first resistor during said second time period, said output voltage $e_{o1}$ being the voltage of said $V_{o1}$ node at the end of said second time period.

11. Apparatus to claim 10, wherein said first current control means comprises: an error amplifier having first and second inputs and an output, said first input of said error amplifier being coupled to receive said $e_{i1}$ voltage during said first time period and said second input of said error amplifier being coupled to said $V_{o1}$ node during said first time period;

a first track/hold unit having an input and an output, said input of said first track/hold unit being coupled to said output of said error amplifier, said output of said first track/hold unit tracking said input of said first track/hold unit during said first time period and holding constant during said second time period; and

a first adjustable current source having a monotonic transfer function, having a first control input coupled to said output of said first track/hold unit, and further having a current output coupled to said first terminal of said first resistor.

12. Apparatus according to claim 11, wherein said first terminal of said first resistor is said $V_{o1}$ node, and wherein said first reference voltage supply means comprises:

a first voltage follower having an output being said $V_{ref1}$ node and having an input, said voltage follower having a DC offset of $e_{DC1}$; and

switching apparatus having an output coupled to said input of said voltage follower, a first input coupled to receive said $e_{i2}$ input voltage and a second input coupled to receive said $e_{i3}$ input voltage.

13. Apparatus according to claim 11, wherein said second terminal of said first resistor is said $V_{o1}$ node, and wherein said first reference voltage supply means comprises:

a first operational amplifier having first and second inputs and an output, said first input of said first operational amplifier being coupled to said first terminal of said resistor and said output of said first operational amplifier being coupled to said second terminal of said resistor, said first operational amplifier having a DC offset of $e_{DC1}$; and

switching apparatus having an output coupled to said second input of said first operational amplifier, a first input coupled to receive said $e_{i2}$ input voltage and a second input coupled to receive said $e_{i3}$ input voltage.

14. Apparatus according to claim 11, further having a $V_{o2}$ node, wherein said error amplifier has a DC offset which affects the accuracy of $e_{o1}$, said apparatus further comprising correction apparatus for generating at said $V_{o2}$ node an output voltage $e_{o2}$ which corrects for the effect on $e_{o1}$ of said DC offset of said error amplifier, said correction apparatus comprising:

a constant voltage node;

a second resistor coupled between said $V_{o2}$ node and said constant voltage node, said second resistor having first and second terminals;

a second adjustable current source having a monotonic transfer function which has a slope having a sign opposite that of said transfer function of said first adjustable current source, said second adjustable current source having a control input coupled to receive said output of said error amplifier during said second time period and further having a current output coupled to said first terminal of said second resistor, said first input of said error amplifier being coupled to receive the voltage at said $V_{o2}$ node during said second time period and said second input of said error amplifier remaining coupled to said $V_{o1}$ node during said second time period, said output voltage $e_{o2}$ being the voltage at said $V_{o2}$ node at the end of said second time period.

15. Apparatus according to claim 11, further for generating at a $V_{o2}$ node an output voltage $e_{o2}$ given by $e_{i1} - e_{i2} + e_{i3} - e_{i4} + e_{i5}$, where $e_{i4}$ and $e_{i5}$ are additional input voltages, said apparatus further comprising:

a second reference voltage supply having an output node $V_{ref2}$ for holding said $V_{ref2}$ node at a fourth reference voltage $e_{i4} + e_{DC2}$ during said second time period and at a fifth reference voltage $e_{i5} + e_{DC2}$ during a third time period subsequent to said second time period, $e_{DC2}$ being a constant voltage offset or zero;

a second resistor coupled between said $V_{o2}$ node and said $V_{ref2}$ node, said second resistor having first and second terminals;

second current control means having a signal input coupled to receive said output of said error amplifier and having a current output coupled to said first terminal of said second resistor, for establishing in said second resistor a second current $I_2$ responsive during said second time period to the signal on said signal input of said second current control means according to a monotonic transfer function having a slope having a sign opposite that of said transfer function of said first adjustable current source, and for maintaining said second current $I_2$ in said second resistor during said third time period, said first input of said error amplifier being coupled to receive the voltage at said $V_{o2}$ node during said second time period and said second input of said error amplifier remaining coupled to said $V_{o1}$ node during said second time period, said output voltage $e_{o2}$ being the voltage at said $V_{o2}$ node at the end of said third time period.

16. Apparatus according to claim 15, wherein said second current control means comprises:

a second track/hold unit having an input being said signal input of said second current control means and further having an output; and

a second adjustable current source having a control input coupled to said output of said second track/hold unit and further having an output being said current output of said second current control means.

17. Apparatus according to claim 10, wherein said first current control means comprises:

an error amplifier having first and second inputs and an output, said first input of said error amplifier being coupled to receive said $e_{i1}$ voltage during said first time period and said second input of said error amplifier being coupled to said $V_{o1}$ node during said first time period;

a first track/hold unit having an input and an output, said input of said first track/hold unit being coupled to said output of said error amplifier, said output of said first track/hold unit tracking said input of said first track/hold unit during said first time period and holding constant during said second time period;

first approximation means having an output, for providing during said first time period an approximation of $\pm(e_{i1} - e_{i2})$ and for holding said approximation of $\pm(e_{i1} - e_{i2})$ during said second time period; and

a first transconductance converter having first and second voltage inputs and a current output and generating at said current output of said first transconductance converter a first total current approximately equal to the sum of a current responsive according to a function $G_{11}$ of the voltage at said first voltage input of said first transconductance converter and a current responsive according to a function $G_{12}$ of the voltage at said second voltage input of said first transconductance converter, said first voltage input of said first transconductance converter being coupled to said output of said first track/hold unit, said second voltage input of said first transconductance converter being coupled to said output of said first approximation means and said current output of said first transconductance converter being coupled to said first terminal of said first resistor, said first approximation means and said functions $G_{11}$ and $G_{12}$ being such that the relationship between said first total current and $(e_{i1} - e_{i2})$ is monotonic.

18. Apparatus according to claim 17, wherein said function $G_{11}$ has a magnitude substantially larger than that of said function $G_{12}$ for a given input voltage.

19. Apparatus according to claim 17, wherein said first approximation means comprises means for generating a finite precision digital representation of said $e_{i1}$ input voltage minus said $e_{i2}$ input voltage and for converting said digital representation to an analog signal $(e_{i1} - e_{i2})^*$ during said first time period, and for holding said signal $(e_{i1} - e_{i2})^*$ during said second time period, said signal $(e_{i1} - e_{i2})^*$ being said output of said first approximation means.

20. Apparatus according to claim 17, wherein said first approximation means comprises:

an analog-to-digital converter having a voltage input and a finite precision digital output, said voltage input of said analog-to-digital converter being coupled during said first time period to receive a voltage approximately proportional to $(e_{i1} - e_{i2})$;

latch means having an output, for coupling to said output of said latch means during said first time period the digital output of said analog to digital converter and for maintaining on said output of said latch means during said second time period the digital output which was generated by said analog-to-digital converter during said first time period; and

a digital-to analog converter having a digital input coupled to said output of said latch means and having an analog output being said output of said first approximation means.

21. Apparatus according to claim 20, wherein said function $G_{11}$ has a magnitude substantially larger than that of said function $G_{12}$ for a given input voltage.

22. Apparatus according to claim 15, wherein said second current control means comprises:

a second track/hold unit having an input and an output, said input of said second track/hold unit being coupled to said output of said error amplifier, said output of said second track/hold unit tracking said input of said second track/hold unit during said second time period and holding constant during said third time period;

second approximation means having an output, for providing during said second time period an approximation of $\pm(e_{o1} - e_{i4})$ and for holding said approximation of $\pm(e_{o1} - e_{i4})$ during said third time period; and

a second transconductance converter having first and second voltage inputs and a current output and generating at said current output of said second transconductance converter a second total current approximately equal to the sum of a current responsive according to a function $G_{21}$ of the voltage at said first voltage input of said second transconductance converter and a current responsive according to a function $G_{22}$ of the voltage at said second voltage input of said second transconductance converter, said first voltage input of said second transconductance converter being coupled to said output of said second track/hold unit, said second voltage input of said second transconductance converter being coupled to said output of said second approximation means and said current output of said second transconductance converter being coupled to said first terminal of said second resistor, said second approximation means and said functions $G_{21}$ and $G_{22}$ being such that the relationship between said second total current and $(e_{o1} - e_{i4})$ is monotonic.

23. Apparatus according to claim 22, wherein said function $G_{21}$ has a magnitude substantially larger than that of said function $G_{22}$ for a given input voltage.

24. Apparatus according to claim 10, further for generating at a $V_{o2}$ node an output voltage $e_{o2}$ given by $e_{i1} - e_{i2} + e_{i3} - e_{i4} + e_{i5}$, where $e_{i4}$ and

$e_{i5}$ are additional input voltages, wherein said first current control means comprises:

an error amplifier having first and second inputs and an output, said first input of said error amplifier being coupled to receive said $e_{i1}$ voltage during said first time period and said second input of said error amplifier being coupled to said $V_{o1}$ node during said first time period;

a first track/hold unit having an input and an output, said input of said first track/hold unit being coupled to said output of said error amplifier, said output of said first track/hold unit tracking said input of said first track/hold unit during said first time period and holding constant during said second time period;

first approximation means having an output, for generating during said first time period an approximation of $\pm(e_{i1} - e_{i2})$ and for holding said approximation of $\pm(e_{i1} - e_{i2})$ during said second time period; and

a first transconductance converter having first and second voltage inputs and a current output and generating at said current output of said first transconductance converter a first total current approximately equal to the sum of a current responsive according to a function $G_{11}$ of the voltage at said first voltage input of said first transconductance converter and a current responsive according to a function $G_{12}$ of the voltage at said second voltage input of said first transconductance converter, said first voltage input of said first transconductance converter being coupled to said output of said first track/hold unit, said second voltage input of said first transconductance converter being coupled to said output of said first approximation means and said current output of said first transconductance converter being coupled to said first terminal of said first resistor, said first approximation means and said functions $G_{11}$ and $G_{12}$ being such that the relationship between said first total current and $(e_{i1} - e_{i2})$ is monotonic,

said apparatus further comprising:

a second reference voltage supply having an output node $V_{ref2}$ for holding said $V_{ref2}$ node at a fourth reference voltage $(e_{i4} + e_{DC2})$ during said second time period and at a fifth reference voltage $(e_{i5} + e_{DC2})$ during a third time period subsequent to said second time period, $e_{DC2}$ being a constant voltage offset or zero;

a second resistor coupled between said $V_{o2}$ node and said $V_{ref2}$ node;

a second track/hold unit having an input and an output, said input of said second track/hold unit being coupled to said output of said error amplifier, said output of said second track/hold unit tracking said input of said second track/hold unit during said second time period and holding constant during said third time period;

second approximation means having an output, for generating during said second time period an approximation of $\pm(e_{o1} - e_{i4})$ during said third time period; and

a second transconductance converter having first and second voltage inputs and a current output and generating at said current output of said second transconductance converter a second total current approximately equal to the sum of a current responsive according to a function $G_{21}$ of the voltage at said first voltage input of said second transconductance converter and a current responsive according to a function $G_{22}$ of the voltage at said second voltage input of said second transconductance converter, said first voltage input of said second transconductance converter being coupled to said output of said second track/hold unit, said second voltage input of said second transconductance converter being coupled to said output of said second approximation means and said current output of said second transconductance converter being coupled to said first terminal of said second resistor, said second approximation means and said functions $G_{21}$ and $G_{22}$ being such that the relationship between said second total current and $(e_{o1} - e_{i4})$ is monotonic.

25. Apparatus according to claim 24, wherein said function $G_{21}$ has a magnitude substantially larger than that of said function $G_{22}$ for a given input voltage.

26. Analog arithmetic apparatus for generating a voltage $eo_2$ equal to $e_{i1} - e_{i2} + e_{i3} - e_{i4} + e_{i5}$ where $e_{i1}$, $e_{i2}$, $e_{i3}$, $e_{i4}$ and $e_{i5}$ are input voltages, comprising:

a $V_{o1}$ node, a $V_{o2}$ node, a $V_{ref1}$ node and a $V_{ref2}$ node;

a first resistor coupled between said $V_{o1}$ node and said $V_{ref1}$ node, said first resistor having first and second terminals;

a first transconductance converter having a monotonic transfer function, having a current output coupled to said first terminal of said first resistor and further having a first control input;

a first track/hold unit having an input and an output, said output of said first track/hold unit being coupled to said first control input of said first transconductance converter, said first track/hold unit having a track mode in which said output of said first track/hold unit tracks said input of said first track/hold unit and having a hold mode in which said output of said first track/hold unit holds constant;

an error amplifier having first and second inputs and an output, said second input of said error amplifier being coupled to said $V_{o1}$ node during said first time period, said output of said error amplifier being coupled to said input of said first track/hold unit during said first time period;

a second track/hold unit having an input and an output, said input of said second track/hold unit being coupled to said output of said error amplifier during said second time period, said second track/hold unit having a track mode in which said output of said second track/hold unit tracks said input of said second track/hold unit and a hold mode in which said output of said second track/hold unit holds constant;

a second transconductance converter having a monotonic transfer function with a slope having a sign opposite that of said transfer function of said first transconductance converter, said second transconductance converter having a first control input coupled to said output of said second track/hold unit;

a second resistor coupled between said $V_{o2}$ node and said $V_{ref2}$ node, said second resistor having first and second terminals; and

control means for,

during a first time period, coupling to said first input of said error amplifier said $e_{i1}$ voltage, applying to said $V_{ref1}$ node a voltage ($e_{i2} + e_{DC1}$), where $e_{DC1}$ is a constant voltage offset or zero, and placing said first track/hold unit in said track mode,

for, during a second time period following said first time period, placing said first track/hold unit in said hold mode, applying to said $V_{ref1}$ node a voltage ($e_{i3} + e_{DC1}$), placing said second track/hold unit in said track mode, applying to said $V_{ref2}$ node a voltage ($e_{i4} + e_{DC2}$), where $e_{DC2}$ is a constant voltage offset or zero, and coupling the voltage of said $V_{o2}$ node instead of said $e_{i1}$ voltage to said first input of said error amplifier,

and for, during a third time period following said second time period, applying a voltage ($e_{i5} + e_{DC2}$) to said $V_{ref2}$ node and placing said second track/hold unit in said hold mode, said voltage of said $V_{o2}$ node in said third time period being said $e_{o2}$ voltage.

27. Analog arithmetic apparatus for generating an analog output signal $a_o$ having a value given by the value of a first analog input signal $a_{i1}$ plus the value of a third analog input signal $a_{i3}$, comprising:
computational means for use with first and second computational means analog input signals each having a value, and for generating a computational means analog output signal having a value equal to said value of said second computational means analog input signal plus some single valued function of said value of said first computational means analog input signal; and
control means for, in a first time period, determining an analog signal $a_c$ having a value such that said computational means generates as said computational means analog output signal a signal having a value substantially equal to said value of said signal $a_{i1}$ when zero is provided as said second computational means analog input signal and said signal $a_c$ is provided as said first computational means analog input signal, and for, in a second time period subsequent to said first time period, providing said signal $a_c$ as said first computational means analog input signal and providing said signal $a_{i3}$ as said second computational means analog input signal, said output signal $a_o$ being generated as said computational means analog output signal during said second time period.

28. Analog arithmetic apparatus for generating an analog output signal $a_o$ having a value given by the value of a third analog input signal $a_{i3}$ minus the value of a second analog input signal $a_{i2}$, comprising:
computational means for use with first and second computational means analog input signals each having a value, and for generating a computational means analog output signal having a value equal to said value of said second computational means analog input signal plus some single valued function of said value of said first computational means analog input signal; and
control means for, in a first time period, determining an analog signal $a_c$ having a value such that said computational means generates as said computational means analog output signal a signal having a value of zero when said signal $a_{i2}$ is provided as said second computational means analog input signal and said signal $a_c$ is provided as said first computational means analog input signal, and for, in a second time period subsequent to said first time period, providing said signal $a_c$ as said first computational means analog input signal and providing said signal $a_{i3}$ as said second computational means analog input signal, said output signal $a_o$ being generated as said computational means analog output signal during said second time period.

29. Analog arithmetic apparatus for generating an analog output signal $a_o$ having a value given by zero minus the value of a second analog input signal $a_{i2}$, comprising:
computational means for use with first and second computational means analog input signals each having a value, and for generating a computational means analog output signal having a value equal to said value of said second computational means analog input signal plus some single valued function of said value of said first computational means analog input signal; and
control means for, in a first time period, determining an analog signal $a_c$ having a value such that said computational means generates as said computational means analog output signal a signal having a value of zero when said signal $a_{i2}$ is provided as said second computational means analog input signal and said signal $a_c$ is provided as said first computational means analog input signal, and for, in a second time period subsequent to said first time period, providing said signal $a_c$ as said first computational means analog input signal and providing zero as said second computational means analog input signal, said output signal $a_o$ being generated as said computational means analog output signal during said second time period.

30. Comparator apparatus for generating an output voltage indicating the sign of the function $e_{i1} - e_{i2} + e_{i3} - e_{i6}$, where $e_{i1}$, $e_{i2}$, $e_{i3}$ and $e_{i6}$ are input voltages, comprising:

a $V_{o1}$ node;

reference voltage supply means having an output node $V_{ref}$ for providing a second reference voltage $(e_{i2} + e_{DC1})$ at said $V_{ref}$ node during a first time period and a third reference voltage $(e_{i3} + e_{DC1})$ at said $V_{ref}$ node during a second time period subsequent to said first time period, $e_{DC1}$ being a constant voltage offset or zero;

a resistor coupled between said $V_{o1}$ node and said $V_{ref}$ node;

an error amplifier having first and second inputs and an output;

means for coupling said first input of said error amplifier to receive said $e_{i1}$ voltage during said first time period, for coupling said first input of said error amplifier to receive said $e_{i6}$ voltage during said second time period, and for coupling said second input of said error amplifier to said $V_{o1}$ node during both said first and second time periods; and

a signal loop including said error amplifier and further including means for establishing in said resistor during said first time period a current I in response to said output of said error amplifier, and for providing in said resistor during said second time period the current I which was in said resistor at the end of said first time period, said means for establishing being such that the net feedback around said signal loop during said first time period is negative,

said output voltage of said comparator apparatus being taken from said output of said error amplifier during said second time period.

31. Comparator apparatus for generating an output voltage indicating the sign of the function $e_{i1} - e_{i6}$, where $e_{i1}$ and $e_{i6}$ are input voltages, comprising:

a $V_{o1}$ node and a constant voltage $V_{ref}$ node;

a resistor coupled between said $V_{o1}$ node and said $V_{ref}$ node;

an error amplifier having first and second inputs and an output;

means for coupling said first input of said error amplifier to receive said $e_{i1}$ voltage during said first time period, for coupling said first input of said error amplifier to receive said $e_{i6}$ voltage during said second time period, and for coupling said second input of said error amplifier to said $V_{o1}$

node during both said first and second time periods; and

a signal loop including said error amplifier and further including means for establishing in said resistor during said first time period a current I in response to said output of said error amplifier, and for providing in said resistor during said second time period the current I which was in said resistor at the end of said first time period, said means for establishing being such that the net feedback around said signal loop during said first time period is negative,

said output voltage of said comparator apparatus being taken from said output of said error amplifier during said second time period.

32. Comparator apparatus for generating an output voltage indicating the sign of the function $e_{i1} + e_{i3} - e_{i6}$, where $e_{i1}$, $e_{i3}$ and $e_{i6}$ are input voltages, comprising:

a $V_{o1}$ node;

reference voltage supply means having an output node $V_{ref}$, for providing at said $V_{ref}$ node a second reference voltage during a first time period and a reference voltage of $e_{i3}$ plus said second reference voltage during a second time period subsequent to said first time period;

a resistor coupled between said $V_{o1}$ node and said $V_{ref}$ node;

an error amplifier having first and second inputs and an output;

means for coupling said first input of said error amplifier to receive said $e_{i1}$ voltage during said first time period, for coupling said first input of said error amplifier to receive said $e_{i6}$ voltage during said second time period, and for coupling said second input of said error amplifier to said $V_{o1}$ node during both said first and second time periods; and

a signal loop including said error amplifier and further including means for establishing in said resistor during said first time period a current I in response to said output of said error amplifier, and for providing in said resistor during said second time period the current I which was in said resistor at the end of said first time period, said means for establishing being such that the net feedback around said signal loop during said first time period is negative,

said output voltage of said comparator apparatus being taken from said output of said error amplifier during said second time period.

33. Comparator apparatus for generating an output voltage indicating the sign of the function $e_{i1} - e_{i2} - e_{i6}$, where $e_{i1}$, $e_{i2}$ and $e_{i6}$ are input voltages, comprising:

a $V_{o1}$ node;

reference voltage supply means having an output node $V_{ref}$, for providing at said $V_{ref}$ node a third reference voltage during a second time period and a reference voltage of $e_{i2}$ plus said third reference voltage during a first time period prior to said second time period;

a resistor coupled between said $V_{o1}$ node and said $V_{ref}$ node;

an error amplifier having first and second inputs and an output;

means for coupling said first input of said error amplifier to receive said $e_{i1}$ voltage during said first time period, for coupling said first input of said error amplifier to receive said $e_{i6}$ voltage during said second time period, and for coupling said second input of said error amplifier to said $V_{o1}$ node during both said first and second time periods; and

a signal loop including said error amplifier and further including means for establishing in said resistor during said first time period a current I in response to said output of said error amplifier, and for providing in said resistor during said second time period the current I which was in said resistor at the end of said first time period, said means for establishing being such that the net feedback around said signal loop during said first time period is negative,

said output voltage of said comparator apparatus being taken from said output of said error amplifier during said second time period.

34. Apparatus for generating the absolute value of an analog input signal, comprising:

means for generating the inverse of said analog input signal;

zero offset comparator means for generating a sign signal indicative of the sign of said analog input signal; and

means for selecting between said analog input signal and said inverse of said analog input signal in response to said sign signal.

35. Apparatus according to claim 34, wherein said analog input signal and said inverse of said analog input signal are both voltage signals, and wherein said zero offset comparator means comprises:

a resistor having first and second terminals;

means for providing at one of said first and second terminals of said resistor a $V_{ref}$ voltage during both a first time period and a second time period;

an error amplifier having first and second inputs and an output, said second input of said error amplifier being coupled to the other of said first and second terminals of said resistor during both said first and second time periods;

means for coupling said first input of said error amplifier to receive one of said analog input signal and said inverse of said analog input signal during one of said first and second time periods and a different voltage during the other of said first and second time periods; and

a signal loop including said error amplifier and further including means for establishing in said resistor during said first time period a current I in response to said output of said error amplifier, and for providing in said resistor during said second time period the current I which was in said resistor at the end of said first time period, said means for establishing being such that the net feedback around said signal loop during said first time period is negative,

said output voltage of said comparator apparatus being taken from said output of said error amplifier during said second time period.

36. Apparatus according to claim 35, wherein said different voltage is zero.

37. Apparatus according to claim 35, wherein said different voltage is the other of said analog input signal and said inverse of said analog input signal.

38. Analog integrating apparatus for integrating in successive pairs of time periods the value $0 - e_{i2} + e_{i3} - e_{i4} + e_{i5}$, where $e_{i2}$, $e_{i3}$, $e_{i4}$ and $e_{i5}$ are input voltages, comprising:

first and second resistors each having first and second terminals;

means for applying to said second terminal of said first resistor a voltage equal to $e_{i2} + e_{DC1}$ during the first time period of each pair of time periods and a voltage equal to $e_{i3} + e_{DC1}$ during the second time period of each pair of time periods, $e_{DC1}$ being a constant DC offset or zero;

means for applying to said second terminal of said second resistor a voltage equal to $e_{i4} + e_{DC2}$ during the first time period of each pair of time periods and a voltage equal to $e_{i5} + e_{DC2}$ during the second time period of each pair of time periods, $e_{DC2}$ being a constant DC offset or zero;

an error amplifier having first and second inputs and an output, said first input of said error amplifier being coupled to said first terminal of said second resistor and said second input of said error amplifier being coupled to said first terminal of said first resistor;

a first signal loop including said error amplifier and further including first means for establishing in said first resistor during the first time period of each given pair of time periods a current $I_1$ responsive to said output of said error amplifier, and for providing in said first resistor during the second time period of said given pair of time periods the current $I_1$ which was in said first resistor at the end of said first time period of said given pair of time periods, said first means being such that the net feedback around said first signal loop during said first time period of said given pair of time periods is negative; and

a second signal loop including said error amplifier and further including second means for establishing in said second resistor during said second time period of said given pair of time periods a current $I_2$ responsive to said output of said error amplifier, and for providing in said second resistor during the time period immediately following said second time period of said given pair of time periods the current $I_2$ which was in said second resistor at the end of said second time period of said given pair of time periods the current $I_2$ which was in said second resistor at the end of said second time period of said given pair of time periods, said second means being such that the net feedback around said second signal loop during said second time period of said given pair of time periods is negative.

39. Digitally enhanced memory apparatus for storing the value of an analog input signal, comprising:
first storage means for storing a digital representation of a first value; and
second storage means for storing a second value being an analog representation of the difference between said first value and said value of said analog input signal.

40. Apparatus according to claim 39, further comprising means for producing an output signal having a value given by the sum of said first value and said second value.

41. Apparatus according to claim 39, further comprising means for generating said first value as an approximation of said value of said analog input signal.

42. Apparatus according to claim 41, wherein said analog input signal is an input voltage, and wherein said second storage means comprises means for storing a voltage proportional by a factor $K > 1$ to said difference between said first value and said value of said analog input signal.

43. Apparatus according to claim 42, wherein $K$ is much larger than 1.

44. Memory apparatus for storing a representation of the value $a_i$ of an analog signal, comprising:
first generating means for generating a representation of a value $a_i^*$, $a_i^*$ being an approximation of $a_i$;
feedback means for generating a representation of a value $a_e$ and adjusting said representation of said value $a_e$ until $(a_i^* + a_e)$ is substantially equal to $a_i$; and
first and second storage means for storing respectively said representations of said values $a_i^*$ and $a_e$.

45. Apparatus according to claim 44, wherein said first generating means comprises ADC means for determining a finite precision digital representation of $a_i$, and wherein said first storage means comprises digital storage means for storing said finite precision digital representation digitally, $a_i^*$ being the value represented by said finite precision digital representation.

46. Apparatus according to claim 44, wherein said first storage means comprises an analog track and hold unit.

47. Apparatus according to claim 44, wherein said second storage means comprises a track/hold unit for storing said representation of $a_e$, and wherein said feedback means comprises:
summing means for producing a signal representing a value $a_o = a^* + a_e$; and
a signal loop including said summing means and further including error means for applying to said track/hold unit a signal indicative of the difference between $a_i$ and $a_o$, said error means and said summing means being such that the net feedback around said signal loop is negative.

48. Memory apparatus for storing an input voltage $e_i$, comprising:
first storage means for storing a representation of a voltage $e_i^*$, $e_i^*$ being an approximation of $e_i$, said first storage means having an input coupled to receive said voltage $e_i$ and further having an output;
a track and hold unit for storing a representation of a voltage $e_e$;
a summer having first and second inputs and an output, said first input of said summer being coupled to receive $e_i^*$ and said second input of said summer being coupled to receive $e_e$; and
a signal loop including said summer and further including an error amplifier having first and second inputs and an output, said first input of said error amplifier being coupled to receive $e_i$, said second input of said error amplifier being coupled to receive said output of said summer, and said output of said error amplifier being applied to said track and hold unit, said summer and said error amplifier being such that the net feedback around said signal loop is negative.

49. Zero offset apparatus for use with a first analog input signal, comprising:
first and second circuit portions each having an analog input and an analog output, said first circuit portion including means for providing on said output of said first circuit portion during a second time period subsequent to a first time period an intermediate signal differing by at most a first offset from the signal that was on said output of said first circuit portion at the end of said first time period;
an error amplifier having first and second inputs and an output, said error amplifier having a non-zero DC offset; and
means for coupling during said first time period said first input of said error amplifier to receive said first analog input signal, said second input of said error amplifier to receive a signal differing from the signal on said output of said first circuit portion by at most a second offset, and said output of said error amplifier to said input of said first circuit

24

portion, and for coupling during said second time period said first input of said error amplifier to receive a signal differing from the signal on said output of said second circuit portion by at most a third offset, said second input of said error amplifier to receive a signal differing from the signal on said output of said first circuit portion by at most a fourth offset, and said output of said error amplifier to said input of said second circuit portion.

50. Apparatus according to claim 49, wherein said means for coupling comprises means for coupling during said first time period said second input of said error amplifier to said output of said first circuit portion, said second offset being zero.

51. Apparatus according to claim 49, wherein said means for coupling comprises means for coupling during said second time period said first input of said error amplifier to said output of said second circuit portion, said third offset being zero.

52. Apparatus according to claim 49, wherein said means for coupling comprises means for coupling during said second time period said second input of said error amplifier to said output of said first circuit portion, said fourth offset being zero.

53. Apparatus according to claim 49, wherein said means for providing comprises means for providing on said output of said first circuit portion during said second time period the signal that was on said output of said first circuit portion at the end of said first time period.

54. Apparatus according to claim 49, wherein said means for providing comprises:
means for controllably generating said first offset; and
means for providing on said output of said first circuit portion during said second time period said first offset plus said signal that was on said output of said first circuit portion at the end of said first time period.

55. Apparatus according to claim 49, wherein said means for coupling comprises means for coupling during said first time period said second input of said error amplifier to said output of said first circuit portion, means for coupling during said second time period said first input of said error amplifier to said output of said second circuit portion, and means for coupling during said second time period said second input of said error amplifier to said output of said first circuit portion.

56. Apparatus according to claim 55, wherein said means for providing comprises:
means for controllably generating said first offset; and
means for providing on said output of said first circuit portion during said second time period said first offset plus said signal on said output of said first circuit portion at the end of said first time period.

57. Zero offset apparatus comprising:
first and second circuit portions each having an analog output and a first analog input;
an error amplifier having first and second inputs and an output, said second input of said error amplifier being coupled to said output of said first circuit portion and said output of said error amplifier being coupled to said inputs of both said first and second circuit portions; and
first coupling means for coupling said first input of said error amplifier to receive said output of said second circuit portion.

58. Apparatus according to claim 57, for use with a first analog input signal, wherein said first coupling means comprises means for coupling said first input of said error amplifier to receive selectably said first analog input signal or said output of said second circuit portion.

59. Apparatus according to claim 57, wherein said first circuit portion comprises:
a first resistor having first and second terminals, said first terminal of said first resistor being coupled to said output of said first circuit portion;
first voltage reference means for providing a desired reference voltage at said second terminal of said first resistor; and
first current source means for providing in said first resistor selectably either a first stored current level or a current level monotonically responsive according to a first function to said output of said error amplifier.

60. Apparatus according to claim 59, for use further with second and third specified voltages, wherein said first voltage reference means comprises means for providing at said second terminal of said first resistor selectably said second or said third specified voltage.

61. Apparatus according to claim 59, wherein said first current source means comprises:
a track/hold unit having an input coupled to said output of said error amplifier and further having an output; and
a controllable current source having an input coupled to said output of said track/hold unit and further having an output coupled to said first terminal of said first resistor.

62. Apparatus according to claim 59, wherein said second circuit portion comprises:
a second resistor having first and second terminals, said first terminal of said second resistor being coupled to said output of said second circuit portion;
second voltage reference means for providing a desired reference voltage at said second terminal of said second resistor; and
second current source means for providing in said second resistor selectably either a second stored current level or a current level monotonically responsive according to a second function to said output of said error amplifier.

63. Apparatus according to claim 62, for use with second, third, fourth and fifth specified voltages, wherein said first voltage reference means comprises means for providing at said second terminal of said first resistor selectably said second or said third specified voltage, and wherein said second voltage reference means comprises means for providing at said second terminal of second resistor selectably said fourth or said fifth specified voltage.

64. Apparatus according to claim 63, for use further with a first analog input signal, wherein said first coupling means comprises means for coupling said first input of said error amplifier to receive selectably said first analog input signal or said output of said second circuit portion.

65. Apparatus according to claim 59, for use with a first analog input signal, wherein said first coupling means comprises means for coupling said first input of said error amplifier to receive selectably said first analog input signal or said output of said second circuit portion, said apparatus further comprising control means:
for controlling said first coupling means to select said first analog input signal during a first time period,
for controlling said first coupling means to select said output of said second circuit portion during a second time period subsequent to said first time period,
for controlling said first current source means to select said current level monotonically responsive according to said first function during said first time period, and
for controlling said first current source means to select said first stored current level during said second time period.

66. Apparatus according to claim 60, further comprising control means:
for controlling said first voltage reference means to select said second specified voltage during a first time period,
for controlling said first voltage reference means to select said third specified voltage during a second time period subsequent to said first time period, for controlling said first current source means to select said current level monotonically responsive according to said first function during said first time period, and
for controlling said first current source means to select said first stored current level during said second time period.

67. Apparatus according to claim 63, further comprising control means:
for controlling said first current source means to select said current level monotonically responsive according to said first function during a first time period,
for controlling said first current source means to select said first stored current level during a second time period subsequent to said first time period,
for controlling said second current source means to select said current level monotonically responsive according to said second function during said second time period, and
for controlling said second current source means to select said second stored current level during a third time period subsequent to said second time period.

68. Apparatus according to claim 67, wherein said control means is further:
for controlling said first current source means to select said current level monotonically responsive according to said first function during said third time period, and
for controlling said first current source means to select said first stored current level during a fourth time period subsequent to said third time period.

69. Apparatus according to claim 64, further comprising control means:
for controlling said first coupling means to select said first analog input signal during a first time period,
for controlling said first coupling means to select said output of said second circuit portion during a second time period subsequent to said first time period,
for controlling said first current source means to select said current level monotonically responsive to said first function during said first time period,
for controlling said first current source means to select said first stored current level during said second time period,
for controlling said first voltage reference means to select said second specified voltage during said first time period,
for controlling said first voltage reference means to select said third specified voltage during said second time period,
for controlling said second current source means to select said current level monotonically responsive according to said second function during said second time period,
for controlling said second current source means to select said second stored current level during a third time period subsequent to said second time period,
for controlling said second voltage reference means to select said fourth specified voltage during said second time period, and
for controlling said second voltage reference means to select said fifth specified voltage during said third time period.

70. Apparatus according to claim 57, wherein said first circuit portion comprises:

a first resistor having first and second terminals, said second terminal of said first resistor being coupled to said output of said first circuit portion;

first voltage reference means for providing a desired reference voltage at said first terminal of said first resistor; and

first current source means for providing in said first resistor selectably either a first stored current level or a current level monotonically responsive according to a first function to said output of said error amplifier.

71. Apparatus according to claim 70, for use further with second and third specified voltages, wherein said first voltage reference means comprises means for providing at said first terminal of said first resistor selectably said second or said third specified voltage.

72. Apparatus according to claim 71, wherein said first current source means comprises:

a track/hold unit having an input coupled to said output of said error amplifier and further having an output; and

a controllable current source having an input coupled to said output of said track/hold unit and further having an output coupled to said first terminal of said first resistor.

73. Apparatus according to claim 70, wherein said second circuit portion comprises:

a second resistor having first and second terminals, said second terminal of said second resistor being coupled to said output of said second circuit portion;

second voltage reference means for providing a desired reference voltage at said first terminal of said second resistor; and

second current source means for providing in said second resistor selectably either a second stored current level or a current level monotonically responsive according to a second function to said output of said error amplifier.

74. Apparatus according to claim 73, for use further with a first analog input signal, wherein said first coupling means comprises means for coupling said first input of said error amplifier to receive selectably said first analog input signal or said output of said second circuit portion.

75. Zero offset apparatus comprising:

a first signal loop including an error amplifier having first and second inputs and an output, said signal loop further including first circuit means for providing to said second input of said error amplifier selectably either a first stored voltage or a voltage level monotonically responsive to said output of said error amplifier, said first circuit means being such that the total feedback around said first signal loop is negative when said first circuit means is selected to provide to said second input of said error amplifier said voltage level monotonically responsive to said output of said error amplifier; and

means for providing to said first input of said error amplifier selectably either a first signal or a second signal.

76. Apparatus according to claim 75, further comprising a second signal loop including said error amplifier and further including second circuit means for providing said second signal as a voltage level monotonically responsive to said output of said error amplifier when said means for providing is selected to provide said second signal to said error amplifier, said second circuit means being such that the total feedback around said second signal loop is negative when said means for providing is selected to provide said second signal to said error amplifier.

77. Apparatus according to claim 76, wherein said second circuit means is further for providing said second signal as a second stored voltage level when said means for providing is not selected to provide said second signal to said error amplifier.

78. Apparatus for use with a first analog input voltage, comprising:

a resistor having first and second terminals;

voltage reference means for providing a desired reference voltage at said second terminal of said resistor; and

circuit means for providing in said resistor selectably either a stored current level or the current level which causes the voltage at said first terminal of said resistor to differ from said first analog input voltage by at most a known offset.

79. Apparatus according to claim 78, wherein said circuit means comprises:

an error amplifier having first and second inputs and an output;

first coupling means for coupling said first analog input voltage to said first input of said error amplifier;

second coupling means for coupling said first terminal of said resistor to said second input of said error amplifier; and

current source means for providing in said resistor selectably either said stored current level or a current level monotonically responsive to said output of said error amplifier.

80. Apparatus according to claim 79, wherein said second coupling means comprises a conductor connecting said first terminal of said resistor to said second input of said error amplifier.

81. Apparatus according to claim 78, for use further with second and third specified voltages, wherein said voltage reference means comprises third coupling means for providing at said second terminal of said resistor selectably said second or said third specified voltage.

82. Apparatus according to claim 79, for use further with second and third specified voltages, wherein said voltage reference means comprises third coupling means for providing at said second terminal of said resistor selectably said second or said third specified voltage, said apparatus further comprising control means:

for controlling said current source means to select said current level monotonically responsive to said output of said error amplifier during a first time period,

for controlling said current source means to select said stored current level during a second time period subsequent to said first time period,

for controlling said voltage reference means to select said second specified voltage during said first time period, and

for controlling said voltage reference means to select said third specified voltage during said second time period.

83. A method for performing an analog computation on first, second and third analog signals, comprising the steps of:

providing a circuit portion;

establishing in said circuit portion during a first time period a first analog quantity being a first function of said first and second analog signals; and

maintaining said first analog quantity in said circuit portion during a second time period while establishing in said circuit portion a second analog quantity being a second function of said first analog quantity and said third analog signal; and

deriving an analog result signal from said second circuit quantity.

84. A method according to claim 83, wherein said circuit portion comprises a resistor having first and second terminals, wherein said first function is a current valued function of the difference between said first and second analog signals, wherein said first analog quantity is the current passing through said resistor, wherein said second analog quantity is the voltage at one of said first and second terminals of said resistor, wherein said third analog signal is a voltage signal, and wherein said second function provides a voltage output given by $a_{i3}$ + IR, where $a_{i3}$ is said third analog signal, I is said first analog quantity and R is the resistance of said resistor.

85. A method for generating a voltage $e_{o1}$ in response to input voltages $e_{i1}$, $e_{i2}$ and $e_{i3}$; comprising the steps of:

in a first time period, establishing a current $I_1$ through a resistor such that the voltage drop from a first end of the resistor to a second end of the resistor substantially equals $e_{i1}$ - $e_{i2}$; and

during a second time period subsequent to said first time period, applying said voltage $e_{i3}$ to said second end of said resistor while maintaining said current $I_1$ through said resistor constant, said output voltage $e_{o1}$ being the voltage during said second time period of said first end of said resistor.

86. A method according to claim 85, further for generating an output voltage $e_{o2}$ further in response to input voltages $e_{i4}$ and $e_{i5}$, further comprising the steps of:

during said second time period, establishing in a second resistor a current $I_2$ such that the voltage drop from a first end of said second resistor to a second end of said second resistor substantially equals $e_{o1}$ -$e_{i4}$; and

during a third time period subsequent to said second time period, applying said voltage $e_{i5}$ to said second end of said second resistor while maintaining said current $I_2$ in said second resistor, said output voltage $e_{o2}$ being the voltage of said first end of said second resistor during said third time period.

87. A method for generating a voltage $e_{o1}$ in response to input voltages $e_{i1}$ and $e_{i2}$, comprising the steps of:

in a first time period, establishing a current $I_1$ through a resistor such that the voltage drop from a first end of the resistor to a second end of the resistor substantially equals $e_{i1}$ - $e_{i2}$; and

during a second time period subsequent to said first time period, applying zero volts to said second end of said resistor while maintaining said current $I_1$ through said resistor constant, said output voltage $e_{o1}$ being the voltage during said second time period of said first end of said resistor.

88. A method for generating a voltage $e_{o1}$ in response to input voltages $e_{i1}$ and $e_{i3}$, comprising the steps of:

in a first time period, establishing a current $I_1$ through a resistor such that the voltage drop from a first end of the resistor to a second end of the resistor substantially equals $e_{i1}$; and

during a second time period subsequent to said first time period, applying said voltage $e_{i3}$ to said second end of said resistor while maintaining said current $I_1$ through said resistor constant, said output voltage $e_{o1}$ being the voltage during said second time period of said first end of said resistor.

89. A method for generating a voltage $e_{o1}$ substantially equal to an input voltage $e_{i1}$, comprising the steps of:

in a first time period, applying a voltage $e_2$ at a second end of a resistor and establishing a current $I_1$ through said resistor such that the voltage at a first end of the resistor equals $e_{i1}$; and

during a second time period subsequent to said first time period, maintaining said voltage $e_2$ at said second end of said resistor and maintaining said current $I_1$ through said resistor constant, said out-

put voltage $e_{o1}$ being the voltage during said second time period of said first end of said resistor.

90. A method for generating a voltage $e_{o1}$ in response to input voltages $e_{i2}$ and $e_{i3}$, comprising the steps of:

in a first time period, establishing a current $I_1$ through a resistor such that the voltage drop from a first end of the resistor to a second end of the resistor substantially equals $-e_{i2}$; and during a second time period subsequent to said first time period, applying said voltage $e_{i3}$ to said second end of said resistor while maintaining said current $I_1$ through said resistor constant, said output voltage $e_{o1}$ being the voltage during said second time period of said first end of said resistor.

91. A method for generating a voltage $e_{o1}$ in response to an input voltage $e_{i2}$, comprising the steps of:

in a first time period, establishing a current $I_1$ through a resistor such that the voltage drop from a first end of the resistor to a second end of the resistor substantially equals $-e_{i2}$; and

during a second time period subsequent to said first time period, applying zero volts to said second end of said resistor while maintaining said current $I_1$ through said resistor constant, said output voltage $e_{o1}$ being the voltage during said second time period of said first end of said resistor.

**FIG. Ia**
**(Prior Art)**

**FIG. Ib**
**( Prior Art)**

| STEP | FUNCTION |
|------|----------|
| 1. | $V_{ref} = e_{i2}$ ; $V_c = e_c$ Such That $V_o = e_{i1}$ |
| 2. | $V_c = e_c$ ; $V_{ref} = e_{i3}$ $\Rightarrow V_o = e_{i1} - e_{i2} + e_{i3}$ |

**FIG. 2**

| STEP | FUNCTION |
|------|----------|
| 1. | $S \rightarrow V_{i2}$ ; $t/h \rightarrow Track$ $\Rightarrow V_o = V_{i1} - e_{DCE}$ $\Rightarrow V_{ref} = V_{i2} - e_{DCR}$ $\Rightarrow IR = V_{i1} - V_{i2} - e_{DCE} + e_{DCR}$ |
| 2. | $t/h \rightarrow Hold$ ; $S \rightarrow V_{i3}$ $\Rightarrow V_{ref} = V_{i3} - e_{DCR}$ $\Rightarrow V_o = IR + V_{ref}$ $= (V_{i1} - V_{i2} - e_{DCE} + e_{DCR}) + (V_{i3} - e_{DCR})$ $= V_{i1} - V_{i2} + V_{i3} - e_{DCE}$ |

**FIG. 3**

FIG. 4

FIG. 5
( Prior Art )

FIG. 6

FIG. 7

FIG. 8

FIG. 9

FIG. 10

| STEP | FUNCTION |
|------|----------|
| 1. | $S_1 = Closed$ ; $S_2 \rightarrow V_{i1}$ ; $S_3 \rightarrow V_{i2}$ |
|  | $\Rightarrow V_{o1} = e_{i1} - e_{DC}$ |
| 2. | $S_1 = Open$ ; $S_3 \rightarrow V_{i3}$ |
|  | $\Rightarrow V_{o1} = e_{o1} = e_{i1} - e_{i2} + e_{i3} - e_{DC}$ |
|  | $S_2 \rightarrow V_{o2}$ |
|  | $\Rightarrow V_{o2} = V_{o1} + e_{DC}$ $= e_{o2} = e_{i1} - e_{i2} + e_{i3}$ |

FIG. IIa

| STEP | FUNCTION |
|---|---|
| 1. | $S_1$ = Closed ; $S_2 \rightarrow V_{i1}$ ; $S_3 \rightarrow V_{i2}$ <br><br> $\Rightarrow V_{o1} = e_{i1} - e_{DC}$ ; $V_{ref1} \approx e_{i2}$ |
| 2. | $S_1$ = Open ; $S_3 \rightarrow V_{i3}$ <br><br> $\Rightarrow V_{o1} = e_{o1} = e_{i1} - e_{i2} + e_{i3} - e_{DC}$ <br><br> $S_4$ = Closed ; $S_2 \rightarrow V_{o2}$ <br><br> $\Rightarrow V_{o2} = V_{o1} + e_{DC}$ <br><br> $\qquad = e_{i1} - e_{i2} + e_{i3}$ <br><br> $S_5 \rightarrow V_{i4}$ <br><br> $\Rightarrow V_{ref2} \approx e_{i4}$ <br><br> $\Rightarrow I_2 R_2 \approx (e_{i1} - e_{i2} + e_{i3}) - e_{i4}$ |
| 3. | $S_4$ = Open ; $S_5 \rightarrow V_{i5}$ <br><br> $\Rightarrow V_{o2} \approx I_2 R_2 + e_{i5}$ <br><br> $\qquad = e_{i1} - e_{i2} + e_{i3} - e_{i4} + e_{i5} \equiv e_{o2}$ |

## FIG. IIb

FIG. 12

FIG. 13

EP 0 378 360 A2

Hold Logic

84

-e_i*

88

90

## FIG. 20

32*VREF
410
430
412
414

BIT1
(MSB)

16*VREF
408
428

BIT 2

8*VREF
406
426

BIT 3

4*VREF
404
424

BIT 4

2*VREF
402
422

BIT 5

416
VREF
(ANALOG
VOLTAGE IN)
420

BIT 6
(LSB)

## FIG. 14

$V_{in}$

452

B
nA+B
A

454

456

$V_2$

450

$V_{out}$

## FIG. 16

FIG. 15

$V_{i1}$

$V_0$

$V_{i2}$  $V_{i3}$  $V_{i4}$  $V_{i5}$

$e_{i2}$  $e_{i3}$

*FIG. 17*

*388*

$V_{i1}$  *380*  $V_0$

*384*  *386*

+

−

$V_{in}$

$V_{i2}$ $V_{i3}$  $V_{i4}$  $V_{i5}$

$V_{out}$

$V_{i1}$  *382*  $V_0$

*390*

$V_{i2}$  $V_{i3}$  $V_{i4}$  $V_{i5}$

*FIG. 18*

FIG. 19

FIG. 21

FIG. 22